(19) Europäisches Patentamt
European Patent Office
Office européen des brevets

(11) EP 4 110 883 B1

(12) **EUROPEAN PATENT SPECIFICATION**

(45) Date of publication and mention of the grant of the patent:
**25.09.2024 Bulletin 2024/39**

(21) Application number: **21708403.7**

(22) Date of filing: **24.02.2021**

(51) International Patent Classification (IPC):
***C09K 11/02** (2006.01)* ***C09K 11/66** (2006.01)*
***C09K 11/88** (2006.01)*

(52) Cooperative Patent Classification (CPC):
**C09K 11/025; C09K 11/02; C09K 11/661; C09K 11/881; C09K 11/883**

(86) International application number:
**PCT/NL2021/050124**

(87) International publication number:
**WO 2021/172986 (02.09.2021 Gazette 2021/35)**

(54) **COLLOIDAL NANOPARTICLE INKS FOR PRINTING OF ACTIVE LAYERS IN AN OPTOELECTRONIC DEVICE**

KOLLOIDALE NANOPARTIKELTINTEN ZUM BEDRUCKEN VON AKTIVEN SCHICHTEN IN EINER OPTOELEKTRONISCHEN VORRICHTUNG

ENCRES À NANOPARTICULES COLLOÏDALES POUR L'IMPRESSION DE COUCHES ACTIVES DANS UN DISPOSITIF OPTOÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.02.2020 EP 20159348**

(43) Date of publication of application:
**04.01.2023 Bulletin 2023/01**

(73) Proprietors:
- **RIJKSUNIVERSITEIT GRONINGEN**
  **9712 CP Groningen (NL)**
- **QDI systems B.V.**
  **9727 DL Groningen (NL)**

(72) Inventors:
- **LOI, Maria Antonietta**
  **9747 AG Groningen (NL)**
- **SHULGA, Artem Gennadiiovych**
  **9727 DL Groningen (NL)**
- **BEDERAK, Dmytro Yaroslavovych**
  **9727 DL Groningen (NL)**

(74) Representative: **V.O.**
**P.O. Box 87930**
**2508 DH Den Haag (NL)**

(56) References cited:
**US-A1- 2017 029 693** **US-A1- 2017 362 255**

- **HAK SOO CHOI ET AL: "Renal clearance of quantum dots", NATURE BIOTECHNOLOGY, vol. 25, no. 10, 23 September 2007 (2007-09-23), us, pages 1165 - 1170, XP055511023, ISSN: 1087-0156, DOI: 10.1038/nbt1340**
- **DATABASE WPI Week 201985, Derwent World Patents Index; AN 2019-88184Q, XP002800007**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Processed by Luminess, 75001 PARIS (FR)

## Description

TECHNICAL FIELD AND BACKGROUND

The present disclosure relates to (manufacturing of) inks with colloidal nanoparticles, such as quantum dots, in particular inks and compositions suitable in the deposition, e.g., printing, of active layers, e.g. for use in optoelectronic devices.

Colloidal suspensions of nanoparticles, nanocrystals and/or quantum dots are used in a broad range of applications including for fabrication of electronic devices such as field-effect transistors (FETs), solar cells, light emitting FETs, light emitting diodes, photodetectors for visible, IR, X-ray or gamma irradiation, phototransistors, thermoelectrics, bolometers and others. Also, water-based dispersions of quantum dots can be used as a platform for bioapplications. Linkers, e.g. ligands on the quantum dot surface allow manufacturing of conjugates of various biological molecules, e.g., using quantum dots as fluorescent markers.

Colloidal quantum dots typically comprise nanocrystals of inorganic material that have discrete energy levels due to quantum confinement of electrons within the volume of the nanoparticles. Quantum dots can be synthesized in a form of a colloidal solution of quantum dots, and after purification can be dispersed in a nonpolar organic solvent such as hexane. In the colloidal solution individual quantum dots are capped with long aliphatic molecules, called ligands. For example, these ligands may include oleic acid (OA) or oleylamine (OAm), which bind to the surface of quantum dots via carboxyl or amine group. The aliphatic tails of the ligands ensure the colloidal stability of such quantum dot solutions, creating repulsive forces between quantum dots counterbalancing the attractive component of van der Waals forces acting on a particle approaching another particle. This way of stabilization is referred to as steric stabilization of colloids. However, such quantum dot solutions are generally less suitable for direct application. For example, the nonpolar solvent may be incompatible with an envisioned biological application. Further, a film deposited from such quantum dot solution typically shows very poor electronic performance. One approach to overcome this problem comprises use of a phase-transfer ligand exchange, which is a method wherein the ligands on the surface of the quantum dots are substituted by different entities, e.g., ligands. Typically, this process is performed in solution.

As background, US6251303B1 discloses a method for manufacturing of water-soluble fluorescent nanocrystals. In the method fluorescent nanocrystals bearing a cap of nonpolar ligands are separated from suspension. The nonpolar ligands are exchanged for a different precursor ligand by exposing the separated fluorescent nanocrystals to a new solution comprising a 30-fold excess of said precursor ligands at elevated temperatures. The nanocrystals can be rendered water soluble in separate step by protonating the precursor ligands. Besides the extensive elaborate manufacturing process disadvantages of the disclosed method include: the presence of a nonpolar ligands and/or the presence of a large excess of unbound precursor ligand in the formed composition; and/or possible nanocrystal degradation or agglomeration due to their length exposure to elevated temperatures.

As further background, Hak Soo Choi et al (Nature biotechnology 25; 1165-1170 (2007) disclose a ligand exchange process that can provide CdSe/ZnS core-shell quantum dots that are capped with cysteamine for bio applications. The process uses a water/chloroform-based ligand exchange process in which the water phase is provided with a phosphate-buffered saline buffer to dissolve the quantum dots. Formed quantum dot suspensions thus comprise a lot of salt and/or a large excess of unbound ligand rendering them less suitable for fabrication of electronic devices.

As further background, Byung-Ryool Hyun eat al (J. Phys. Chem. B 2007, 111, 20, 5726-5730) disclose a multi-step method of manufacturing water-soluble lead salt quantum dots for near-infrared fluorescence imaging. The method uses a large excess of ligand and includes precipitation of QDs followed by a subsequent reaction to render the quantum dots water soluble.

As further background, Noipa T et al (Spectrochim Acta A Mol Biomol Spectrosc. 2014 Jan 24;118:17-23) disclose a method of manufacturing cysteamine CdS quantum dots decorated with $Fe^{3+}$ as a fluorescence sensor for the detection of pyrophosphate. The CdS quantum dots were directly synthesized with cysteamine ligands using a one-pot synthesis. During synthesis the dots do not benefit from the stabilizing effect of long aliphatic ligands. Formed dots were found to be of lower quality and thus less suitable for electronic grade quantum dot inks.

As further background, US2007174939A1 discloses methods of making quantum dot films for use in optical and optoelectronic devices. The method comprises pre-fabricate quantum dots and ligand exchange. Similar to US6251303B1 the ligand exchange includes precipitating the as-synthesized quantum dots from their original solution and dispersing the separated particles in a liquid comprising the exchange ligands. Accordingly, the method of US2007174939A1 shares one or more of the disadvantages described in relation to US6251303B1.

As further background, Database WPIWeek 201985Thomson Scientific, London, GB;AN 2019-88184Q-& WO 2019/203240 A1 (Shoei Chem Inc) 24 October 2019 (2019-10-24) describes a nanoparticle manufacturing system comprising inflow systems, rotor, stator and collection system; and manufacture of nanoparticle ink formulation, which involves mixing and processing solutions in the shear flow reactor to form a product mixture containing mixed nanoparticle ink.

SUMMARY

The method of manufacturing of an ink composition comprising the biphasic ligand exchange process according to the present invention aims to mitigate one or more of the disadvantages described above and/or offering one or more further advantages in the manufacturing of electronic devices from the ink compositions.

Aspects of the present disclosure relate to a method of manufacturing of an ink composition according to claim 1. A first phase liquid comprises a nonpolar solvent with a suspension (a colloidal suspension) of nanoparticles dispersed in the nonpolar solvent. The nanoparticles, e.g. quantum dots, are capped with a shell of first ligands comprising a surface binding head group and an alkyl or alkenyl tail for at least initially keeping the nanoparticles (quantum dots) in a colloidal suspension in the nonpolar solvent. A second phase liquid comprises a polar solvent with second ligands dissolved therein. The second ligand has a molecular architecture including at least one surface binding head group that has an affinity for binding to a surface site of said nanoparticle. Furthermore, the architecture includes at least an ionically charged tail group and a counter ion associated therewith. A biphasic ligand exchange process is used wherein the second ligand displace the first ligands that are bound to the nanoparticles. Thereby, the first ligands are released to the first phase liquid. The biphasic ligand exchange process involves contacting the first and second phase liquid. This forms a dispersion of the nanoparticles, e.g., the quantum dots, that are capped with a shell of the second ligands in the second phase liquid. The nanoparticles that are capped with a shell of the second ligands can be separated from the second phase liquid. The separated nanoparticles (quantum dots) that are capped with a shell of the second ligands can be (re)dispersed in a printable liquid medium. In this way an ink can be formed of which the printing properties may be further tuned, e.g. by addition of other or further additives.

Further aspects of the present disclosure relate to a dry composition, comprising the nanoparticles, preferably quantum dots, that are capped with a shell of second ligand obtainable by any of the methods as described herein, wherein the method further comprises drying the separated quantum dots that are capped with a shell of the second ligands.

Yet, further aspects of the present disclosure relate to an ink composition comprising nanoparticles that are capped with a shell of polar organic ligands according to claim 8. The ink composition comprising a colloidal suspension of quantum dots in a polar printable liquid medium, wherein the quantum dots are capped with a shell of second ligands and wherein the second ligand has a molecular architecture including: at least one surface binding head group that has an affinity for binding to a surface site of said quantum dot; and an ionically charged tail group and a counter ion associated therewith.

Even further aspects relate to the use of a dry composition obtainable according to the disclosed method in the manufacturing of a printable ink composition, and to the use of the ink as described herein, preferably quantum dot based inks, for the manufacturing of optoelectronic devices. Accordingly, aspects of the present disclosure also relate to a method of manufacturing an imaging device comprising a stack of photoactive layers including at least a p-type photoactive layer and/or an n-type photoactive layer. The method comprising depositing one or more layers of the ink composition comprising a p-type dopant as described herein or of the ink obtainable by the method as described herein; and depositing one or more layers of the ink composition comprising a n-type dopant as described herein or of the ink obtainable by the method as described herein, to from a stack of photoactive layers including at least a p-type photoactive layer and/or an n-type photoactive layer, and wherein the photoactive layers are amorphous, comprising a disordered structure of nanoparticles resulting from deposition of the respective ink composition.

As will become clarified herein below the disclosed method, ink, and intermediary products offer certain advantages. These include provision of a facile and/or versatile ligand exchange process allowing manufacturing of quantum dots that are capped with a broad variety of second ligands. Advantageously, nanoparticle degradation can be mitigated as manufacturing of the ink can be performed at room temperature and/or without the presence of harsh conditions, e.g. without exposure to high concentration of strong acids or bases. Further, separating the nanoparticle that are capped with a shell of the second ligands from the second phase comprising a first polar solvent and re-dispersing the quantum dots in a different polar liquid, e.g. a liquid printing medium, allows optimizing properties of the ink, e.g. the type of solvent comprised therein, independent from selection criteria governed by the ligand exchange process.

Further, the optical and electronic properties of obtained nanoparticle can remain stable, e.g., over prolonged periods of time, as dry compositions of obtained nanoparticle that are capped with a shell of the second ligands can be stored without losing essential functionality. Advantageously stored compositions can be (re)dispersed in a suitable printable liquid medium before usage.

The two phase ligand exchange process according to the present invention can be understood to yield capped nanoparticles that were found to be particularly beneficial for use in the manufacturing of a photoactive layer of an optoelectronic device by providing a combination of advantageous properties. Advantages include that the particles manufactured according to the disclosed process were found to be essentially free of hydrophobic ligand moieties and/or oily or waxy impurities that were associated with the nanoparticles as synthesized. As such the biphasic ligand process according to the present invention can be understood as a purification or cleaning procedure allowing to essentially

replace the an initial hydrophobic capping layer, including possible contaminants, by a replacement capping layer of different functional moieties as disclosed herein. As will be clarified herein the replacement capping layer offers improved optoelectronic properties. In addition the replacement capping layer was found to effectively stabilize the nanoparticles in dry form while allowing (re)solubilization of dried particles in polar solvents including ink compositions for use in the manufacturing of a photoactive layer for optoelectronic devices.

BRIEF DESCRIPTION OF DRAWINGS

These and other features, aspects, and advantages of the apparatus, systems and methods of the present disclosure will become better understood from the following description with examples, appended claims, and accompanying drawing wherein:

FIG 1A schematically illustrates a biphasic ligand setup;
FIG 1B schematically illustrates a biphasic ligand exchange process at an initial stage, e.g., shortly after contacting the liquids;
FIG 2A schematically illustrates a later stage of a biphasic ligand exchange process;
FIG 2B schematically illustrates a container containing isolated nanoparticles that are capped with a shell of second ligands;
FIGs 3A-F schematically depicts various second ligands for use with the method as described herein;
FIG 3G schematically depicts exemplary polymeric additives for use in the ink as described herein;
FIG 4A schematically depicts a step in the manufacturing of an ink composition;
FIG 4B schematically depicts a container with an ink composition;
FIG 5 schematically illustrates a cross-section side view of an imaging device comprising a photoactive layer manufactured using an ink as described herein;
FIG 6A schematically illustrates observed color changes during an embodiment of the method as described herein;
FIGs 6B-D display photographs of vials at various stages during embodiments of the method as described herein;
FIGs 7A-B illustrate optical properties of an exemplary quantum dot composition;
FIGs 8A-B illustrate optical properties of an exemplary quantum dot composition;
FIG 8C illustrates aspects of large scale manufacturing;
FIGs 9A-B illustrate properties of an exemplary optoelectronic device comprising quantum dots;
FIGs 10A-B illustrate properties of an exemplary optoelectronic device comprising quantum dots;
FIGs 11A-B illustrate properties of an exemplary optoelectronic device comprising quantum dots;
FIGs 12A-B illustrate properties of an exemplary optoelectronic device comprising quantum dots;
FIGs 13A-B illustrate properties of an exemplary optoelectronic device comprising quantum dots; and
FIGs 14A-B illustrate properties of an exemplary optoelectronic device comprising quantum dots.

DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

Unless specified otherwise, properties of compounds of mixtures, e.g., solubility, referred to herein are specified at room temperature and standard pressure, e.g. twenty degrees Celsius and one atmosphere.

(Colloidal) Nanoparticles comprise a dense core of inorganic material that has at least one dimension lower than one thousand nanometer, e.g. in a range between one, or ten, Angstrom and one hundred nm, preferably in a range between about one nanometer and about fifty nanometer, e.g. a about two to ten nanometer, e.g. three nanometer. Colloidal nanocrystals (NCs) of semiconducting materials with distinctive electronic properties determined by their size are often referred as quantum dots (QDs) or colloidal quantum dots (QCDs) due to quantum confinement effect. Advantages of QDs include: size-tunable band gap, high light absorption coefficient and solution processability.

Quantum dots synthesized from solution are typically referred to as colloidal quantum dots or colloidal nanocrystals. As synthesized, colloidal quantum dots are generally capped with long aliphatic ligands (such as oleic acid or oleylamine), ensuring homogeneous growth of the nanoparticles and the colloidal stability of the solution. For certain

nanoparticles other ligands including and not limited to various phosphines and phosphine oxides (such as trioctylphosphine and trioctylphosphine oxide) can be employed. Quantum dots can be manufactured using other methods including plasma synthesis. Quantum dots synthesized by plasma are usually in the form of powder, for which surface modification, e.g. passivation with aliphatic ligands may be carried out.

Nanoparticles have been reported for a broad range of compositions. Examples include mono-elemental nanoparticles (Ag, Au, Ni, Ru, Rh, Pd, Pt, Sn, Si, Ge, Ga, In, Fe, Mn, Co, Cu, Be, C, B, Al, Sb, Li, Na, K, Y, lanthanide, etc.), carbonaceous-based nanoparticles, metal and/or lanthanide oxide nanoparticles ($Fe_2O_3$, $Fe_3O_4$, MnO, $Mn_2O_3$, $Mn_3O_4$, MgO, CaO, BaO, ZnO, $TiO_2$, NiO, $Ni_2O_3$, $In_2O_3$, $Ga_2O_3$, $Be_2O_3$, $Y_2O_3$, $SiO_2$, $V_2O_3$, $V_2O_5$, $CeO_2$, $Al_2O_3$, $GeO_2$, $ZrO_2$, $HfO_2$, CuO, $Cu_2O$, $SnO_2$, $WO_3$, $Au_2O_3$, $BaFe_{12}O_{19}$, $As_2O_3$, $Bi_2O_3$, $Bi_2O_5$, CoO, CdO, PbO, HgO, $Au_2O_3$, $Li_2O$, $Na_2O$, $K_2O$, $Rb_2O$, $Cs_2O$, SrO, $Ln_2O_3$ where Ln represents a lanthanide element etc), chalcogenide nanoparticles (e.g., ZnX, CdX, PbX, HgX, BiX, $Cu_2X$, CuX, $Bi_2X_3$, $Bi_2X_5$, $In_2X_3$, $Al_2X_3$, GaX, $Ga_2X_3$, SnX, $SnX_2$, FeX, $FeX_2$, NiX, $Ni_2X_3$, CoX, $Co_2X_3$, $GeX_2$, MnX, $Mn_2X_3$, $Ag_2X$, $MoX_2$, $WX_2$, $Cr_2X_3$, where X represents S, Se, or Te), pnictogenide nanoparticles (BX, AlX, GaX, InX, $Si_3X_4$, wherein X represents N, P, As, or Sb), carbide nanoparticles (SiC, TiC, WC, $MoC_2$, HfC, ZrC), and mixtures of thereof. It will be understood that particles suitable for use with the invention are not to be construed as to be limited to the listed exemplary compositions. Particles comprising a mixture or combination of the abovementioned materials can be equally used to advantage, including for example, core/shell structures or segmented particles, and also alloys, such as AgInS2, and/or doped particles.

The shape of the nanoparticles can be understood to include, but not limited to, spheres, cylinders, discs, toroids, wires, rods, needles, cubes, cuboctahedrons, parallelepipeds (bar), tetrahedral, octahedral, icosahedra, dodecahedra, prisms, nanoplates, nanofoil, nanotubes, of various shape (quadratic, triangular, rectangular, hexagonal etc), stars, tetrapods, hyperbranched and branched. Abovementioned nanoparticles can be provided in a core/shell configuration or core/shell/shell structures having layers of different composition, wherein the interface between layers of different composition may be a sharp interface or gradual interface. The nanoparticlescan be hollowed or porous or could combine two or more shapes of one or more materials.

It will be understood that the biphasic ligand exchange process as described herein can be used to advantage for a broad variety of nanoparticles, including nanocrystals and quantum dots. A process or step as described herein below that is explained relation to a specific type of nanoparticle, e.g. a quantum dots, is not to be inferred as to be limited to that specific type of nanoparticle. Rather, a selection of nanoparticles type can be understood to be governed by a target application, e.g. based on a requirement of an active component in an optoelectronic device.

Unless specified otherwise, non polar solvents used herein may be understood to include, linear-, branched-, cyclic-, or halogenated alkanes, alkenes, and alkynes, as well as aromatic compounds. Nonpolar solvents include but are not limited to pentanes, like n-pentane and 2,2,4-trimethylpentane, hexanes, like n-hexane, heptanes, octanes, nonane, decane , dodecane, hexadecane, 1-octadecene, petroleum ether, poly($\alpha$-olefin)s and oligo($\alpha$-olefin)s, squalane, cyclopentane, cyclohexane, benzene, toluene, ethylbenzene, xylenes, like p-xylene, trimethylbenzenes, cumene, chlorobenzene, dichlorobenzenes, 1,2,4-trichlorobenzene, fluorobenzene, difluorobenzenes, hexafluorobenzene, biphenyl, diphenyl oxide, cresols, terphenyls, mesitylene, nitrobenzenen, tetralin, decalin, dichloromethane, trichloromethane, tetrachloromethane, carbon disulfide, trichloroethylene, 1,1,1-trichloroethane, tetrachloroethylene, ethyl acetate, diisopropyl ether , diethyl ether and mixtures thereof.

Unless specified otherwise, polar solvents used herein may be understood to include, but not limited to, methanol, ethanol, propanol, isopropanol, butanol, ethylene glycol, glycerol, 1,3-butanediol, ammonia, hydrazine, acetone, acetonitrile, benzonitrile, formamide, N-methylformamide, dimethylformamide, dimethylacetamide, dimethylsulfoxide, hexamethylphosphoramide, propylene carbonate, N-methyl-2-pyrrolidone, nitromethane, methylamine, dimethylamine, ethylamine, propylamine, butylamine, triethylamine, trimethylamine, ethanolamine, methoxyethanol, ethylenediamine, dimethylethylenediamine, tetramethylethylenediamine, tetrakis(dimethylamino)ethylene, pyridine, 2,6-difluoropyridine, water and mixtures thereof.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

FIGs 1-2 schematically illustrate manufacturing of an ink composition 100 at various stages.

FIG 1A schematically illustrates a biphasic ligand setup. The setup as shown is formed by a container 50, e.g. beaker. Of course also other setups can be used. Preferably, the container has at least a transparent side wall portion such that progress may be followed visually.

Added to the container 50 is a first phase liquid 10. The first phase liquid 10 comprises or is essentially formed

of a nonpolar solvent 11 or a mixture of nonpolar solvents. Dispersed in the solvent is a suspension (a colloidal suspension) of quantum dots 1. The quantum dots 1 are capped with a shell 2s of first ligands 2. The ligands comprise a surface binding head group 2h that binds to a surface site on the quantum dot. The ligands further comprise a nonpolar alkyl or alkenyl tail 2t for at least initially keeping the quantum dots 1 in a colloidal suspension in the nonpolar solvent 11. The shell 2s of first ligands (indicated by a dashed circle) is sometimes referred to as a corona, may be understood to included a volume around the quantum dot that is occupied by the second ligands. Quantum dots synthesized from solution are typically referred to as colloidal quantum dots or colloidal nanocrystals. As synthesized, colloidal quantum dots are generally capped with long aliphatic ligands (such as oleic acid or oleylamine) which are believed to ensure homogeneous growth of the nanoparticles and the colloidal stability of the solution. Quantum dots can be manufactured using other methods including plasma synthesis. For quantum dots not already comprising a shell of first of ligands the method, e.g., a powder of quantum dots synthesized by plasma, the method includes a step of capping the quantum dots with a shell 2s of first ligands 2.

Typically, the type and/or composition of the quantum dots can depend on its desired application. The method as disclosed herein is not to be construed to be limited to a certain type and/or composition of quantum dots per se. The disclosed method of forming an ink was found to work for a broad range of quantum dots that are capped with a shell of aliphatic ligands which are sufficiently labile to be replaced by second ligands. Suitable quantum dots include but are not limited to Au, PbS, PbSe, and CdSe quantum dots as well as multi-layer dots comprising such outer coating.

Added to the container 50 is a second phase liquid 20. The second phase liquid comprises or is essentially formed of a polar solvent 21 or mixture of polar solvents in which an amount of second ligand 3 is dissolved.

Optionally, a third solvent (co-solvent) can be added to the biphasic mixture. The third solvent being miscible with the liquids that make up the first and second phase liquids. Addition of a co-solvent was found to promote, speed up, ligand exchange. Miscibility of the third solvent being defined as forming a single phase fluid with an equal volume of the nonpolar solvent, respectively with an equal volume of the first polar solvent.

The second ligand has a multi-block molecular architecture that includes at least one surface binding head group 3h that has an affinity for binding to a surface site of the quantum dots 1, and an ionically charged tail group 3t and a counter ion 3c associated therewith. Typically, the second ligand comprises an organic spacer 3s separating the head group and the tail group. Details regarding the second ligand will be described later. It was found that further additives, such as pH-buffers, are not required to drive the ligand exchange reaction to completion. As additives, such as pH-buffers or ionic strength modifiers, can be particularly difficult to remove, and/or can negatively affect optoelectronic properties of the quantum dots, the second phase liquid is preferably free of such additives, i.e. consist of a solution of one or more second ligands in a polar solvent or mixture of solvents.

The first and second phase liquid may be understood to be mutually essentially immiscible. Mutually essentially immiscible liquids, e.g. the first and second phase liquid, can spontaneously form a biphasic liquid system. Providing mutually essentially immiscible phases can advantageously be separated form each other relative ease, e.g. by decanting or pouring. The exact composition of the first and second phase liquid can depend on the type of quantum dot and/or of the type of the first ligands capping said quantum dot. Preferably, the first phase liquid can disperse the quantum dots that are capped with a shell of first ligands in a concentration of at least 10 mg/mL. Likewise, the first phase liquid can preferably dissolve the first ligands in a concentration of at least 10 mM.

The second phase liquid is a poor dispersing medium for the first ligands and for the quantum dots that are capped with a shell of first ligands. Preferably, the solubility of the first ligands in the second phase liquid is below 0.1 mM. Preferably, the solubility of the quantum dots that are capped with the first ligands in the second phase liquid is below 0.1 mg/mL, or lower, e.g. below 0.01 mg/mL, preferably practicable negligible. The second phase liquid is a good solvent for the second ligands. The higher the solubility of the second ligands the better dispersing medium the second phase liquid can be for quantum dots that are capped with a shell of the second ligands. The solubility of the second ligands is preferably at least 10 mM, preferably higher e.g. at least 20 mM or more, e.g. at least 30 mM. The higher the concentration of the second ligands the faster the ligand exchange reaction can be.

The first and second phase liquid may each individually comprise a single solvent or a mixture of solvents. In some embodiments, the first phase liquid comprises a nonpolar solvent or mixture of nonpolar solvents. A nonpolar solvent sometimes referred to as an apolar solvent, may be understood to include solvents having a low net dipole moment. Preferably the nonpolar solvent has a dipole moment below 1.5 D (Debye units/ $1\times10^{-18}$ statcoulomb-centimeters). The lower the dipole moment of a solvent the lower the solubility of polar compounds in that solvent. More preferably, the nonpolar solvent has a dipole moment below 1.0 D or lower, e.g., below 0.5 D, e.g., in a range between 0.35 and 0 D. Choice of the first phase liquid, including the one or more polar solvents may be limited by an availability, e.g. a commercial availability, of quantum dots that are capped with a shell of first ligands. For quantum dots that are capped with a shell of ligands comprising a surface binding head group and an alkyl or alkenyl having a number of carbon atoms n in a range between 12 and 20, e.g. oleic acid, oleylamine, ocdadecylamine and hexdecanoic acid) inventors found that first phase liquids comprising or essentially consisting of one or more aliphatic solvents, including but not limited to hexanes and octane to be suitable. The polar solvent 21, may be understood to include solvents having

a high net dipole moment. Preferably, the polar solvent has a dipole moment above 1.5 D (Debye units/ $1\times10^{-18}$ statcoulomb-centimeters). The higher the dipole moment of a solvent the lower the solubility of nonpolar compounds in the solvent. More preferably, the nonpolar solvent has a dipole moment above 1.6 D or higher, e.g., above 2, e.g., in a range between 1.5 and 5.

The difference in dipole moment and/or logP (n-octanol/water) were found to provide further selection criteria. The difference in dipole moment between the first and second phase liquids was found to be preferably at least 0.5D. The higher the difference the lower the mutual solubility between the liquid phases. Preferably, the difference in dipole moment between the first and second phase liquids is higher, e.g. at least 0.7 D or at least 1.0 D or more. Suitable polar solvents were typically found to have a negative logP value. Solvents with a negative logP value were generally found to be good solvents for the second ligands. Preferably, the polar solvents has a logP below about negative 0.2. Solvents with a lower logP value were generally found to be less miscible in the first phase liquid and/or less good solvents for the first ligands.

By adding the first and second phase liquids including their respective constituents to a common container a two phase system is formed in which the respective liquids are separated across a common interface. Across the interphase a ligand exchange process, a biphasic ligand exchange process, can start wherein the second ligand displaces the first ligands that are bound to the quantum dots 1.

FIG 1B schematically illustrates the biphasic ligand exchange process at an initial stage, e.g., shortly after contacting the liquids. Contacting typically includes adding the first and second phase liquids in a common container 50, e.g., a vial. The second phase liquid can be added to a container provided with an amount of the first phase liquid, or vice versa, i.e. adding the first liquid to a container comprising the second phase liquid. Optionally or additionally, the second ligands or a part thereof may be added in a separate step, e.g., to a common container comprising the first and second phase liquids, e.g. in response to an observed or determined progress of the ligand exchange reaction. In the figure as shown the first phase liquid 10 and second phase liquid 20, respectively including the nonpolar solvent 11 with the quantum dots 1 that are capped with a shell of first ligands 2, and the polar solvent 21 with the second ligand 3 interact over a common interface 19 (indicated in the figure with a dash-dot line). As the reaction proceeds across an interface an increased contact area can reduce a required contact time. To increase the effective area of contact, the method preferably includes agitating the contacted first and second phase liquids, e.g. by shaking or stirring.

At the interface ligands (first ligands 2), initially bound to the surface of the quantum dots 1, are displaced by the second ligand 3. It is believed that the exchange reaction proceeds on account of the higher surface affinity of the head group 3h of the second ligand 3 towards the quantum dot compared to the affinity of the head group 2h of the first ligand 2. Displaced first ligand moieties are thereby released ligands to the first phase liquid 10.

FIG 2A schematically illustrates a later stage of the biphasic ligand exchange process, i.e. during contacting the first 10 and second phase liquid 20. By contacting the first 10 and second phase liquid 20 for a suitable time the exchange reaction can proceed to completion forming a dispersion of quantum dots 1 that are capped with a shell 3s of the second ligands 3 in the second phase liquid. As the reaction proceeds second ligand 3 moieties in solution are consumed and incorporated in the shell 3s. In some embodiments, e.g., as shown, the second phase liquid 20 may comprise a remainder (an excess) of ligands 3' after essentially all quantum dots 1 are capped with a shell 3s of the second ligands 3.

In some embodiments the method comprises washing the second phase liquid 20 which contains quantum dots capped with a shell of the second ligands 3s with one or more portions of a solvent for the first ligand. Washing the quantum dots that are capped with a shell of the second ligands 3s in second phase liquid 20 with one or more portions of a solvent for the first ligand can reduce an amount of free (unbound) first ligand in the product, which can be dissolved in liquid 20 in a minor concentration. Contaminations, e.g. an excess of ligand, can form a non-conductive or interfering domains in printed layers of quantum dots. As such the excess ligands which can negatively impart properties, e.g., electrical conductance, of a sensing material layer.

In some embodiments, the dispersion of quantum dots 1 that are capped with a shell 3s of the second ligands 3 in the second phase liquid may be considered to be an ink 100 composition. As will become clear below, the quantum dots 1 that are capped with a shell 3s of the second ligands 3 are preferably separated from the second phase liquid.

The quantum dots 1 that are capped with a shell 3s of the second ligands 3 are preferably essentially free of contaminants, i.e. highly pure. Contaminants, e.g. unbound ligands, salts, grease and/or wax, were found to negatively affect photoelectrical properties of the particles, e.g. of a film formed from an ink comprising said particles and impurities. Mitigating introduction and/or reducing a level of impurities is preferred over subsequent removal or purification procedures, as such subsequent cleaning or purification procedures, e.g. washing steps, can impact particle stability. Purity can be understood to be defined as the mass fraction of the quantum dots with a shell of the second ligands in the final dry powder. Preferably, the purity of the quantum dots is 90%, more preferably above 99%.

FIG 2B schematically illustrates a container 51 containing isolated quantum dots 1 that are capped with a shell of second ligands 3s. The isolated quantum dots 1 that are capped with a shell of second ligands 3s can be obtained by separating the quantum dots that are capped with a shell of the second ligands are separated from the second phase

liquid. Separating the quantum dots that are capped with a shell of the second ligands from the second phase liquid including possible excess unbound second ligands dissolved therein, is preferably preceded by separating said second phase from the first phase liquid, e.g., by decanting, pouring or suctioning.

Separation of the quantum dots that are capped with a shell of the second ligands from the second phase liquid may be attained by any suitable method known in the field. Preferably, separation may be attained by centrifuging, to sediment the second ligand capped quantum dots from the polar phase. Centrifuging was found to be a reliable and fast method to separate particles from suspension forming a pellet of quantum dots 1 that are capped with a shell 3s of the second ligands 3. The separates quantum dots, e.g. in the form of a pellet, may be retrieved and stored easily. Quantum dots that are capped with a shell of the polar ligands when provided in a dry form, e.g. essentially in a solid form, were found to display improved stability compared to quantum dots that are stored in a fluid. Storage in dry form may mitigate quantum dot degradation, e.g. due to Oswald ripening. Storage under inert atmosphere, e.g., $N_2$, may further mitigate quantum dot degradation, e.g. due to oxidation. In some embodiments, separating comprises adding of an anti-solvent to precipitate the quantum dots. The supernatant comprising a possible excess of free unbound second ligands can be discarded. Preferably, separation further includes a drying step, e.g. a vacuum drying step, to evaporate remaining solvent.

The second ligands comprise at least one surface binding head group that has an affinity for binding to a surface site of the quantum dots; and an ionically charged tail group and a counter ion associated therewith as defined in claim 1. The head group of the second ligand binds to the surface of the quantum dots, i.e. surface atoms of the quantum dots, via a hetero atom. The nature of the quantum dots, i.e. the type of binding sites available on an outer surface of the quantum dot, can determine selection of the type of surface binding head group of the second ligands. The surface binding head group comprises a thiol head group. Moieties comprising sulfur-based functional groups, e.g. thiols, thioesters and disulfides, are known to readily bind to a broad variety of surfaces by formation of a covalent metal-sulfur bond. Suitable surfaces including metal surfaces like Au and Ag, and semi-conductor surfaces including but not limited to chalcogenic materials such as CdS, CdSe, PbS, PbSe. Accordingly, for quantum dots of which the outer surface comprises such materials, the surface binding head of the second ligands is thio-based.

The charged tail group of the second ligand provides the quantum dots with a shell that includes electrically charged groups. The charge functionality can be provided by a permanent ionic charge or a functional group which can become charged, e.g. a conjugate acid of a weak base or a conjugate base of a weak acid. Suitable charged tail groups group include, but are not limited to, carboxylates, sulphonic acids, phosphites, phosphonates, hydroxyls, sulphonates, amines, quaternary ammonium salts, carbocations, carboanions, etc. In some embodiments, the charged tail group includes acid adducts of a weak organic base, e.g., a hydrochloride adduct of a primary-, secondary or ternary amine. In other or further embodiments, the charged tail group includes a water soluble salt of an organic acid, e.g. sodium carboxylates or sulfonates.

The organic spacer separating the head group and the tail group can in principle be formed by any organic group that links, covalently links, the head group to the tail group as defined in claim 1. Depending on a desired application of the quantum dots the nature of the linker may play a more or less important role. For example, in applications wherein the quantum dots are comprised in a dense functional layer, e.g., an electrically conductive sensing layer, the size or length of the length of the spacer influences the interdistance between adjacent quantum dots within a dense layer of quantum dots. The organic spacer is a short spacer. The shorter the spacer the closer the quantum dots, i.e. the lower the particle-particle interdistance, can be in sensing layers formed from an ink comprising the quantum dots that are capped with second ligands. The shorter the particle-particle interdistance the better the optoelectronic properties can be. The spacer is an aliphatic spacer, e.g. $-C_nH_{2n}-$, wherein the number of carbon atoms (n) equals 1, 2 or 3.

FIG 3A schematically depicts Markush formulas representing classes of second ligands 3 as described herein. The class of compounds depicted in FIG 3A comprises a thiol head group (SH) for binding the second ligand to the surface of the quantum dots. The charged tail group (Y) represents: an acid adduct of a weak organic base, e.g., a hydrochloride adduct of a primary-, secondary or tertiary amine; or a water soluble salt of an organic acid, e.g. sodium carboxylates or sulfonates. The spacer is an alkyl spacer having a total number of carbon atoms n in a range from 1 to 3. In some preferred embodiments, the charged tail group is formed by an acid adduct of an organic amine, e.g. as shown in FIG 3C wherein R1 and R2 each individually represent an H or a methyl group, and wherein X represents a halide, preferably Cl. In other or further embodiments, the charged tail group is formed by a metal salt of a weak organic acid, e.g. as shown in FIG 3B, wherein M represents an alkali metal, preferably Na. In some embodiments, the second ligands can be formed in situ, e.g. as a product of a reaction in the second phase liquid 20. Generating the second ligand (3) in situ, e.g. as a dissociation product of a corresponding disulfide, can enlarge a number of available ligands, e.g. to ligands which may lack commercial availability. Suitable reactions include formation of the acid adduct of a weak organic base and formation of a metal salt of a weak organic acids, respectively by reaction of a strong acid or strong base with the corresponding weak organic base or weak organic acid. Suitable second ligand 3 moieties may further be dissociation products of a corresponding disulfide precursor moiety.

Exemplary second ligands 3 as described herein include cysteamine hydrochloride (FIG 3E), sodium 2-sulfanylethanesulfonate (FIG 3D), and 2-(dimethylamino)ethanethiol hydrochloride (FIG 3F).

Inventors found that for the class of second ligands 3 as described herein (e.g., as described in relation to FIGs 3A-F) N,N-dimethylformamide, N-methylformamide, or a combination thereof are particularly suitable as polar solvent 21.

Inks comprising quantum dots capped with a layer of cysteamine hydrochloride, cysteamine hydrobromide, sodium 2-sulfanylethanesulfonate, potassium 2-sulfanylethanesulfonate, or 2-(dimethylamino)ethanethiol hydrochloride were found to be stable for at least 24 hours. Quantum dots capped with a layer of cysteamine hydrochloride, cysteamine hydrobromide, sodium 2-sulfanylethanesulfonate, potassium 2-sulfanylethanesulfonate, or 2-(dimethylamino)ethanethiol hydrochloride were found to be particularly suitable in the manufacturing of a photoactive layer for optoelectronic devices such as solar cells, near-infrared photodetectors and X-ray detectors.

Contact time may be determined by process conditions, including but not limited to the concentration of the quantum dots in the first phase liquid and/or the concentration of second ligands in the second phase liquid, process temperature, and agitation conditions. To reduce contact time, the method preferably includes agitating the contacted first and second phase liquids, e.g. shaking or stirring, to increase the contact area between the phases. Preferably, contact between the first and second phase liquids is stopped after completion of the reaction, preferably within one hour of completion of the ligand exchange, or faster. Stopping the reaction preferably also includes separating the formed quantum dots that are capper with a shell of second ligands from the second phase liquid (the polar solvent). Stopping the reaction faster reduces a likelihood of contamination and/or of quantum dot degradation, e.g. by Oswald ripening. Typically the contact time is in the order of seconds or minutes, up to hours, e.g. about 30 seconds, about 1-5 minutes, about 15 minutes to one hour, or more. Progress of the ligand exchange can be determined experimentally, e.g. by chemical analysis and/or optically, to minimize contact time.

The amount (concentration times volume) of second ligands in the second phase is in excess with respect to the number of available binding sites on the quantum dots. The amount of second ligands in the second phase is at least sufficient to displace the aliphatic ligands, preferably all aliphatic ligands, from the quantum dots. The required amount can be determined experimentally. Progress of the ligand exchange reaction can for example be followed visually. Inventors find that the speed and completeness of ligand exchange correlates with the concentration of second ligands. Inventors found that the exchange reaction can proceed faster with higher concentrations of second ligands. The concentration of second ligands in the second phase is at least one hundred micro molar ($\mu$M). Preferably higher, e.g. at least one milli molar (mM) or at least ten mM or more, e.g. about thirty mM. A maximum solubility of the second ligands in the second phase can determine an upper concentration limit. Typically the concentration is below ninety percent of a maximum solubility

In a preferred embodiment, the amount of the second ligand that is dissolved in the polar solvent 21 does not exceed about 1.5 times, preferably below 1.05 times, a pre-determined required amount of the second ligand relative to an amount needed to completely cap the quantum dots 1 with a shell 3s of the second ligands. The exact amount of second ligand to be added can be determined experimentally. A too low amount may result in an incomplete or partial transfer of quantum dots from the first to the second phase liquid which can be observed visually. Presence of an excess of ligand can e.g., be determined by analysis of the solvent, e.g. the supernatant obtained after centrifuging. Alternatively, thermogravimetric analysis (TGA) can be used to measure an amount of second ligand that is to be added. This amount can be related to a mass fraction of first ligands bound to the colloidal nanoparticle. Typically, the ligand fraction in a colloidal PbS sample capped with oleic acid ranges from 10 to 50 wt % of the total weight (the weight of QD core and the capping layer of first ligands). Assuming a TGA analysis of a given QD composition shows 30 wt % mass fraction of oleic acid, and taking into account the molar mass of the ligand (282.45 g/mol), it can be calculated that a 1 mL sample comprising 20 mg/mL of such QD composition is to be contacted with an amount of second ligands that is at least 21.2 micromoles.

In some embodiments, the concentration of QDs in the first phase liquid is between about 0.5 and 100 mg/mL, e.g., 50, 30, 20, 10, 5 or 1 mg/ml. To enhance mixing, the relative volumes of the first and the second phase liquid are preferably in a range between about three to one to about one to three, more preferably the volumes of the first and the second phase liquid are about equal,. Typically, for 1 mL of a first phase liquid comprising about 20 mg/mL PbS QDs about 1 mL of second phase ligand comprising about 30 mM of second ligands 3 is used. Preferably the excess of free ligand is smaller. Preferably the amount of second ligand 3 is in a range between about one and 1.01 times the pre-determined required amount. By providing the second ligands in an amount which is close to the pre-determined required the quantum dots may be capped with a shell of second ligands while at the same time an amount (concentration) of free (unbound) ligands in the polar solvent is minimized. In other words, the ligand moieties are preferably added in an amount such that, following the ligand exchange reaction, the resulting suspension of quantum dots that are capped with a shell of the second ligands has a close to zero concentration of free, unbound, ligand moieties in solution. By minimizing the amount of free ligand moieties in the ink, the particle interdistance in dense layers formed from such ink can be further reduced, e.g. further mitigate increase in particle-particle interdistance due to a presence of free ligands. Accordingly, in some embodiments, the method comprises the step of determining the required amount of the second ligand that is to be dissolved in the polar solvent 21 relative to an amount needed to cap the quantum dots 1 with a shell

3s of the second ligands.

In some embodiments, the step of determining the pre-determined required amount may be performed in a separate experiment. The step of determining the pre-determined required amount need not be included in each manufacturing cycle. The amount of second ligand added to the polar solvent 21 can be calculated (e.g. in dependence of a type and/or mass of quantum dots) from data obtained from a separate earlier experiment.

FIG 4A schematically depicts a further step in the manufacturing of an ink composition. In a preferred embodiment, e.g. as shown, the method of manufacturing of an ink composition, comprising dispersing the separated quantum dots 1 that are capped with a shell 3s of the second ligands in a polar printable liquid medium 30. The printable liquid medium 30 may be added from a separate container 52 to a container 53 containing the, e.g., a pellet of, separated quantum dots 1 that are capped with a shell 3s of the second ligands, or vice versa. The ink may comprise one or more additive 31,32. Additives include but are not limited to dopants, humectants, fillers, stabilizers and polymers. FIG 4B schematically depicts a container 53 containing an ink composition 100 comprising p-type dopants 31 and an additional additive 32.

Inventors further found that it was possible to disperse (e.g. redisperse) dry compositions of quantum dots that are capped with a shell of the second ligands in a polar solvent composition, e.g. a second polar solvent different from the first polar solvent in the ligand exchange process. Inventors find that the presence of charges in the shell helps dispersing and stabilizing the quantum dots 1.

The polar solvent composition in the ink (the second polar solvent) may or may not be of the same composition as the solvent comprised in the second phase liquid 20. Separating the quantum dots that are capped with a shell of the second ligands from the second phase comprising a first polar solvent and re-dispersing the quantum dots in a different polar liquid, e.g. a liquid printing medium, allows optimizing properties of the ink independent from selection criteria governed by the ligand exchange process.

The step of dispersing the separated quantum dots need not be directly follow the separating step. Inventors found that the separated quantum dots that are capped with a shell of the second ligands can advantageously be stored for prolonged periods without essentially losing functionality. Inventors found that the separated quantum dots can be stored for a period in excess of four weeks, before being used to formulate the printable ink. The separated quantum dots that are capped with a shell of the second ligands, e.g. pellets of the precipitated or sedimented quantum dots 1, are preferably dried, e.g. under vacuum, preferably right after separation, and before further usage.

The printable ink composition may be understood to relate to any medium that allows convenient and reliable deposition of a film of quantum dots on a target substrate. Suitable deposition methods include but are not limited to inkjet printing, blade coating, doctor blading, spin coating, slot-die coating, spray coating or any other known application method for depositing a liquid. Upon drying of the film substrates may be coated with films, or dense (dry) layers, of quantum dots that are capped with a shell of the second ligands. As such the printable ink composition can be used in the manufacturing of a variety of electronic devices, e.g. in the manufacturing of dense layers, e.g. photo-active sensing layers, for sensing applications such as near-infrared photodetectors or X-ray detectors. Such dense active layers can be manufactured by deposition and drying a layer of the ink composition on a target substrate, e.g. covering a set of electrodes.

For inks that are intended for use in the manufacturing of photo-electric sensing layers of electronic devices such as X-ray detectors, the quantum dots are preferably based on heavy metal compounds. Preferably, is such embodiment, the quantum dots comprise heavy atoms, e.g. PbS, PbSe. Typically, in a large crystal the band gap of PbS and PbSe is very small and not suitable for electronic applications. Advantageously, in the form of quantum dots the band gap increases and the film of PbS quantum dots can be used as a photosensitive semiconductor with variable band gap (in the range of 0.8-1.4 eV, more or less). Heavy metal-based quantum dots are particularly suitable as constituents of photo-active layers in devices for X-ray detection.

In some embodiments, e.g. as shown in FIGs 4A and B, the printable liquid medium comprises a p-type dopant 31 or a n-type dopant (not shown). The dopants may be organic and/or of inorganic nature. Various coordination compounds of transition metals can be used as n- or p-type dopants, depending on the specific compound. P-type dopants can be any known type of dopant including: organic p-type dopants, such TCNQ (tetracyanoquinodimethane) and/or polymeric p-type dopants; and inorganic p-type dopants, such as or nanoparticles like NiO or $WO_3$ nanoparticles and/or $Fe^{3+}$ salts such as $FeCl_3$ or $FeBr_3$ . N-type dopants can be any known type of dopant including: organic n-type dopants, such as TBAF (tetra-n-butylammoniumfluoride) and n-DMBI (4-(2,3-Dihydro-1,3-dimethyl-1H-benzimidazol-2-yl)-N,N-dimethylbenzenamine) and/or polymeric n-type dopants; and inorganic n-type dopants, such as or nanoparticles like ZnO or $SnO_2$ nanoparticles or alkaline metals compounds such as $Cs_2CO_3$ or $Rb_2CO_3$. Preferably, the dopants should be miscible with the second polar solvent in sufficient concentrations. The optimal dopant concentration depends on the type of quantum dot and intended application and can be derived experimentally for a given combination of dopant and quantum dot film.

The printable liquid medium comprises a polar solvent (second polar solvent) or mixture of polar solvents 30 to disperse the quantum dots 1 that are capped with the shell 3s of second ligands 3. In some embodiments, the second

polar solvent essentially consists of pure water, i.e. water without co-solvents. The pH of the printable liquid medium is preferably such that the tail group essentially remains charged, such that the capping layer does not lose its stabilizing character by protonation, respectively deprotonation, of the charged tail group of the second ligands. For water-based inks in which the second ligand comprises a conjugate base of an acid, the concentration of protons in the ink is preferably at least order of magnitude below the equilibrium pH of a pure solution of the corresponding weak acid (pH < pKa - 1). For water-based inks in which in which the second ligand comprises a conjugate acid of a base the concentration of protons in the ink is preferably at least order of magnitude higher the equilibrium pH of a pure solution of the corresponding base (pH > pKa + 1). The other pH limit of the ink (i.e. the maximum pH, or minimum pH respectively) can be governed by a known, or separately determined, stability of the quantum dot, e.g., towards etching. For quantum dots capped with cysteamine hydrochloride satisfactory colloidal stability of the ink was observed for a printable liquid medium with a pH that is in a range between about 1 to about 9. For quantum dots capped with sodium 2-sulfanylethanesulfonate or potassium 2-sulfanylethanesulfonate satisfactory colloidal stability of the ink was observed for a printable liquid medium that has a pH in a range about 7 to about 13.

The concentration of the quantum dots that are capped with a shell of the second ligands can vary on a broad range. A preferred quantum dot concentration depends on the application and the film deposition method. The quantum dot concentration in the inks the can be in a broad range from about 0.1 or 1 mg/mL up to about 300 mg/ml. High concentrations can advantageously allow deposition of thick dry films in a single deposition run. Excessively high concentrations can compromise long term ink stability. Inks with a concentration of quantum dots that is in a range between about 1 mg/ml up to about 100 mg/ml, preferably between about 3 and about 50 mg/ml, were found to yield a good balance between ink stability and quality of deposited films.

A shown in FIG 4B, the printable liquid medium can comprise one or more further additives as such disclosed herein. The type and amount of additives depend on an intended application.

In some embodiments, the ink comprises stabilizers. Stabilizers, e.g. antioxidants, can stabilize ligands which may degrade, e.g. oxidize. For example, if the ligand comprises a thiol or disulfide group, which can be easily oxidized (for example by oxygen) stabilizers may be added to the liquid medium. Examples of such stabilizers include but are not limited to dithiothreitol, glutathione, β-mercaptoethanol, sodium borohydride, tris(2-carboxyethyl)phosphine, ascorbic acid, N-acetylcysteine, γ-glutamylcysteine, and bacillithiol.

In some embodiments, the ink comprises a humectant. After depositing a layer of the ink on a target surface, and after evaporation of the lower boiling solvents the humectant is believed to remain in the dense film of quantum dots where it is found to improve the properties, e.g. the morphology, of the formed film. Improvement of film properties can be observed experimentally, e.g., by an improved optoelectronic properties of the film, e.g. in sensing layers for X-ray detectors. In some embodiments the humectant is a pyrrolidone. Pyrrolidone, e.g. 2-pyrrolidinone, can further improve wettability and/or reduce surface tension of the ink enabling deposition of more homogeneous quantum dot films compared to inks not comprising pyrrolidone. The concentration of pyrrolidone in the ink can be found experimentally by monitoring the morpholoy and/or electrical response of a deposited film. Similar to a presence of excess ligands an excess of pyrrolidone can increase the interdistance between adjacent quantum dots in a deposited dense film. Accordingly, in practice, and in particular for inks targeted to the deposition of dense quantum dot layers for optoelectronic applications (e.g. X-ray detectors), the amount (mass) of added pyrrolidone is below ten percent of the mass of second ligands comprised in the ink, preferably less, e.g. below five percent, e.g. in a range between 0.1 and one weight percent.

In other or further embodiments, the ink comprises one or more polymeric additive 33. FIG 3G schematically depicts exemplary polymeric additives 33a, 33b, 33c for use in the ink as described herein. Polymeric additives were found to improve printing properties of the ink. Polymeric (non-conjugated polymers) additives, preferably branched polymeric additives, were found improve ink properties, e.g. sprayability (droplet stability) thus facilitating deposition of a homogenous ink layer. Suitable polymers include, but are not limited to, branched polyethlenimine 33a, poly(acrylic acid) 33b and poly(sodium 4-styrenesulfonate) 33c. Incorporation of charged polymeric additives was further found to improve quality of deposited layers. Inventors find the observed improvement to be related to an improved adhesion of the layer to the substrate, thus mitigating delamination. Alternatively or additionally, polymers can serve as a matrix for the quantum dots, e.g. in a film formed after drying a layer of ink. Dielectric polymers or other dielectric molecules may reduce a dark current in an optoelectronic active sensing layer of an imaging device. Examples of suitable dielectric polymers include and are not limiting to polyethylene glycol, poly(methyl methacrylate), polyethylenimine, polyvinylpyrrolidone, and polyvinyl alcohol. Electrically conductive polymers may be incorporated to improve printing properties of the ink while retaining electrically conductive properties of the additives. Suitable electrically conductive materials include electrically conductive polymers includinge, but are not limited to, polythiophenes, PFNI-B (Poly[(9,9-di(3,3'-N,N'-trimethyl-ammonium) propyl fluorenyl-2,7-diyl)- alt-co-(1,4-phenylene)] diiodide salt), and water soluble fullerene derivatives such as WSC70PI (Solaris Chem Inc.).

The concentration of the polymeric additives can be determined experimentally. For branched PEI with a $M_W$ of about 25 kDa a suitable additive concentration in a range between 0.5 and 2.5 mg/mL was experimentally determined for inks with a quantum dot concentration of 20 mg/mL. For inks with other concentrations additive levels may be adjusted

accordingly.

In some preferred embodiments, wherein the polar solvent in the printable liquid medium consists of a mixture of water and ethylene glycol, wherein the volume fraction of ethylene glycol in the mixture is in a range between five and fifty percent. Inks wherein liquid medium is essentially formed of water were found to display poor wetting behavior, e.g. break-up of deposited liquid film, which is believed to be a result of the high surface tension of water. Addition of ethylene glycol was found to improve wetting behavior and/or improve film formation. High fractions of water can be preferred from a cost and/or environmental perspective. Inventors found that part of the ethylene glycol can initially stay incorporated in the film upon deposition because of high boiling point. Inventors found that, upon complete drying, evaporation of this remainder can lead to significant undesirable volume shrinking of the film. Accordingly, the volume fraction of ethylene glycol in the mixture is preferably in a range between ten and thirty percent.

In other preferred embodiments, the polar solvent printable liquid medium 30 is an at least partially fluorinated lower alcohol. Lower alcohols may be understood to include alcohols having a total number of carbon atoms n of six or less. Compared to water and/or mixtures of water and ethylene glycol at least partially fluorinated lower alcohols or mixtures thereof, advantageously have a comparatively low surface tension. Inks having a comparatively low surface tension were found to display improved wetting behavior when deposited on a substrate. Compared to water and/or ethylene glycol, at least partially fluorinated lower alcohols advantageously have a high vapor pressure compared to water. Inks comprising solvents having a comparatively high vapor pressure were found to advantageously display improved, e.g. faster and/or more complete, drying when deposited on a substrate. Quantum dots capped with dimethyl(amino)ethanethiol hydrochloride were found to display excellent colloidal stability in at least partially fluorinated lower alcohols such as 2,2,2,-trifluoroethanol and hexafluoroisopropanol. Furthermore, ternary solvent blends, including fluorinated alcohol, water and ethylene glycol can be advantageous. Fluorinated alcohol (FA) can reduce the surface tension effectively, thus the fraction of ethylene glycol can decrease. Therefore, less ethylene glycol will remain in the film. In some preferred embodiments, the blend comprises FA in a range between 20-50 vol%, water in a range between 40 and 80 vol%, and ethylene glycol in a range between 3 and 10 %.

As shown and described in relation to FIG 2B aspects of the present invention relate to a dry composition, comprising the quantum dots that are capped with a shell of second ligand 3 obtainable by any of the methods as described herein, wherein the method further comprises drying the separated quantum dots that are capped with a shell of the second ligands. In some embodiments, the composition is essentially formed of the quantum dots that are capped with a shell of second ligand 3. In other embodiments the dry composition may comprise one or more of the additives, e.g. stabilizers, dopants, and the like as described herein. These dry compositions may be stored before being used to formulate an ink composition.

As shown and described in relation to FIGs 1-4 and in accordance with the described method aspects of the present invention relate to an ink composition comprising quantum dots that are capped with a shell of polar organic ligands. The ink composition comprising

- a suspension of quantum dots in a polar printable liquid medium 30, wherein the quantum dots are capped with a shell 3s of second ligands 3, wherein the second ligand 3 has a molecular architecture including: at least one surface binding head group 3h that has an affinity for binding to a surface site of said quantum dot; and an ionically charged tail group 3t and a counter ion 3c associated therewith.

The amount of free unbound ligand moieties in the ink is below 10 pM, preferably lower, e.g. <1 μM. Most preferably, the ink composition is essentially without unbound (free) ligand moieties.

In some embodiments, the solvent comprised in the ink consists of a mixture of water and ethylene glycol, wherein the volume fraction of ethylene glycol in the mixture is in a range between ten and fifty percent.

In other embodiments, the solvent comprised in the ink consists of an at least partially fluorinated lower alcohol.

In other or further embodiments, the liquid printable liquid medium further comprises a p-type dopant or a n-type dopant.

As described herein the ink 100 as described herein and the method of manufacturing thereof are particularly suited for the manufacturing of dense layers comprising the quantum dots that are capped with a shell 3s of second ligands 3. These dense layers are suitable as sensing layers in a number of optoelectronic applications, including solar cells, photodetectors and X-rays sensors or even imaging devices having improved photo-electric properties. The invention provides a solution of scalable fabrication of high quality thick (> 1 micron) semiconducting PbS QD films in ambient conditions, capable to detect X-ray radiation with a 10-fold sensitivity in comparison to a-Se detectors. Accordingly, the present invention relates to the use of the inks, e.g. in a manufacturing method of manufacturing an imaging device. The ink can also be used to advantage in other electronic devices such as field-effect transistors (FETs), solar cells, light emitting FETs (LEFETs), photodetectors for visible, IR or gamma irradiation and phototransistors.

FIG 5 schematically illustrates a cross-section view of an imaging device 1000 comprising a photoactive layer 110 manufactured using an ink 100 as described herein. Manufacturing of the imaging device 1000 comprises at least:

- depositing, e.g. on a substrate comprising an electrode structure, one or more layers of the ink composition comprising a p-type dopant as described herein or of the ink obtainable by the method as described herein; and
- depositing one or more layers of the ink composition comprising a n-type dopant as described herein or of the ink obtainable by the method as described herein; and

to from a stack of photoactive layers 110 including at least a p-type photoactive layer 110p and an n-type photoactive layer 110n, wherein the photoactive layers are amorphous, comprising a disordered structure of quantum dots resulting from deposition by applying respective ink compositions.

In one embodiment, as shown in FIG 5, the imaging device 1000 comprises a stack of photoactive layers 110 including at least a p-type photoactive layer 110p and an n-type photoactive layer 110n. The term n-type refers the negative charge of the electron "e-", and means that electrons are the majority carriers in the semi-conductive layer while holes are the minority carriers. Conversely, the term p-type refers the positive charge of the hole "h+", and means that holes are the majority carriers in the semi-conductive layer while electrons are the minority carriers. As shown in FIG 5 , light with wavelength $\lambda$ may create an exciton electron hole pair where the charges may be separated to flow to the different electrodes 130t,130b.

Typically, n-type or p-type semiconductors are created by doping an intrinsic semiconductor with donor impurities. Alternatively or in addition the type of layer may be determined by appropriate selection of ligands. In a preferred embodiment, one or more, preferably all, of the photoactive layers comprise quantum dots (QD) formed by semiconductor quantum dots capped by ligand as described herein.

The photoactive layers are amorphous, e.g. comprising a disordered structure of quantum dots. Advantageously the ink as described herein advantageously yields photoactive layers that are amorphous, comprising a disordered structure of quantum dots resulting from deposition by applying respective solutions comprising colloidal quantum dots (CQD). The formation of amorphous photoactive layers, comprising a disordered structure of quantum dots, is believed to relate to the presence of the charged capping layer that surround the quantum dots. Preferably, each type of photoactive layer is deposited in a single (fluid) processing step, e.g. by spray coating, as opposed to a layer-by-layer deposition. Advantageously the ink as described herein advantageously can have a concentration of 1 mg/mL up to 300 mg/mL of quantum dots 1 that are capped with a shell 3s of second ligands 3 in a range photoactive which allows deposition, e.g. by spray coating of a photoactive layer in a single fluid processing step. By setting the quantum dot concentration layers that have a thickness in the order of micrometers can be obtained, e.g. layers between hundred and five hundred nanometer or layers with a thickness between one and thousand micrometer.

In some embodiments, the quantum dots are essentially separated by the ligands, e.g. without inorganic matrix there between. In some embodiments, the type of the photoactive layer is at least partially determined by inorganic dopants added to the layer. In other or further embodiments, the type of the photoactive layer is exclusively, essentially, or predominantly determined by inorganic dopants added to the layer. In one embodiment, the layers exclusively differ by the type of inorganic dopants. Alternatively, or additionally, it can be envisaged to use organic molecules/polymers as matrix.

The imaging device 1000 comprises readout electronics comprising electrodes 13t,13b sandwiching the photoactive layers 110 (with possibly other layers there between). Typically, at least one of the electrodes 13b is divided in respective pixels 100p for collecting photo-generated charges from respective parts of the photoactive layers. In a preferred embodiment, each pixel 100p comprises an amplification circuit to amplify the photo-generated charge which will be described in further detail below.

In a preferred embodiment, as shown, the stack of photoactive layers 110 comprises at least three different types of photoactive layers including an intermediate photoactive layer 110i between the p-type photoactive layer 110p and the n-type photoactive layer 110n.

Suitable materials for the semiconductor quantum dots 1 may depend on the application. For instance, PbS and PbSe quantum dots are well suited for visible and near- to mid-infrared light absorption, CdSe - for visible light, and PbS, PbSe, CdTe - for X- and gamma-ray absorption.

Optionally, as shown, further layers can be added to the stack. In the embodiment shown, an electron transport layer 120e is provided between one of the electrodes 130t and the n-type photoactive layer 110n. In the embodiment shown, a hole transport layer 120h is provided between the other electrodes 130b and the p-type photoactive layer 110n. Typically, the top electrode 130t is transparent at least to the wavelength $\lambda$ of light to be measured by the detector. Alternatively, the stack can be reversed, e.g. using a transparent substrate and bottom electrode (not shown).

In some embodiments, as shown e.g. in FIG 1A, a scintillating layer 210 is provided between the stack of photoactive layers 110 and a front side of the device 1000 receiving light. For example, the scintillating layer may be configured to convert lower wavelength (high frequency) radiation such as X-ray into higher wavelength (low frequency) light such as visible or near-infrared. Furthermore, the quantum dots may be configured, e.g. having a size and material, to absorb the visible or near-infrared light converted by the scintillating layer and thus allow detection of the lower wavelength. In this way an X-ray detector may be provided. Of course, the shown scintillating layer may also be omitted

in other embodiments to provide e.g. a visible light sensor. For example, in these or other embodiments, the intermediate photoactive layer 110i may comprise relatively small quantum dots. For example, the quantum dots comprise lead sulfide (PbS) or other material.

As described herein, relatively small quantum dots may have an average or median diameter of less than four nanometer. This may allow e.g. visible light absorption. Conversely, relatively large quantum dots may have an average or median diameter of more than four and half nanometer. This may allow e.g. infrared light absorption.

In some embodiments the intermediate photoactive layer 110i comprises relatively large quantum dots compared to quantum dots in the p-type photoactive layer 110p and the n-type photoactive layer 110n. For example, the relatively larger quantum dots in the intermediate photoactive layer 110i may be larger by at least a factor 1.1, 1.2, 1.5, or more. For example, the quantum dots in the intermediate photoactive layer 110i may be >4.5 nm. This may provide a relatively small band gap to absorb (near)infrared light. So in this way a near infrared detector may be provided.

In some embodiments e.g. as shown in FIG 1A, the intermediate photoactive layer 110i has a layer thickness Di larger than the layer thicknesses Dp,Dn of both the p-type photoactive layer 110p and the n-type photoactive layer 110n, e.g. by at least a factor two, five, ten, hundred, or even thousand. For example, a typical layer thickness Dp and/or Dn of the n- and p-type photoactive layers 110p,110n is preferably between ten and hundred nanometer, more preferably between twenty and fifty nanometer. For example, in the embodiments of a visible or x-ray sensor according to FIG 1A, or a (near) infrared sensor according, a typical layer thickness Di of the intermediate photoactive layer 110i is preferably between hundred and ten hundred nanometer, more preferably between hundred and five hundred nanometer, more preferably between two hundred and three hundred nanometer.

In some embodiments, the intermediate layer thickness can be on the order of micrometers, e.g. between one and thousand micrometer, preferably between ten and hundred micrometer. For example, the quantum dots in a relatively thick intermediate layer may provide a direct conversion radiation sensor where the quantum dots absorb ionizing radiation. Preferably, is such embodiment, the quantum dots comprise relatively heavy atoms and have large band gap, e.g. PbS or other material with diameter less than four nanometer.

EXAMPLES

Aspects of the invention will now be illustrated by the following non-limiting examples.

In a first example a dispersion of oleate-capped PbS quantum dots in 1ml of hexane with 20 mg/ml of quantum dots is transferred in a vial containing 1 ml of a 30 mM solution of cysteamine hydrochloride in DMF (or 30 mM solution of MESNA in NMF). The vial is shaken at room temperature until all the QDs are transferred into the polar phase. This takes about 30s. Progress of the reaction was followed by monitoring the color of the phases. At the start of the ligand exchange process the colored quantum dots are comprised in the nonpolar phase. Transfer of the color to the polar phase is an indication that the colloidal suspension of the quantum dots 1 that are capped with a shell of second ligand is formed in the polar phase. FIG 6A schematically depicts observed color changes. Shown to the left is a vial 50 comprising a first phase liquid 10 and a second phase liquid 20 at the onset of the ligand exchange process LE (compare FIG 1A). Shown to the right is a vial 50 comprising a first phase liquid 10 and a second phase liquid 20 after completion of the ligand exchange process LE (compare FIG 2A). The experiment was repeated with similar results using NMF as solvent. When DMSO or water was used as solvent in the second phase liquid 20 incomplete ligand transfer was observed.

After completion of the ligand exchange the nonpolar phase was discarded and the polar phase was washed 3 times with 1 ml of hexane. The QDs are then precipitated by centrifugation. After the centrifugation the supernatant was discarded, and the pellet was dried in vacuum until the remaining solvent evaporates. Further, the pellet can stay in nitrogen environment until the device fabrication moment. The pellet was dispersed in a 80/20 volume/volume mixture of water/ethylene glycol shortly before device fabrication.

FIG 7A depicts a streak camera image of the emission from the PbS QDs capped with cysteamine hydrochloride in water. The arrow follows a trajectory with increasing units in accordance with the color scale.

FIG 7B depicts a photo-luminescence spectrum of the PbS QDs capped with cysteamine hydrochloride in water.

FIG 8A depicts a Time-Resolved Photoluminescence (TRPL) a spectrum of the PbS QDs capped with cysteamine hydrochloride in water. The PL lifetime was determined to be 1.1 $\mu$s.

It was found that the ligand exchange processes according to the invention can be scaled up to the multigram scale without essentially affecting the properties of the formed QDs. The photo a 1L separation funnel comprising the biphasic mixture after the complete ligand exchange as shown in FIG 8C illustrates the possibility to upscale the process.

FIG 8B depicts absorption spectra of PbS QDs capped with native oleic acid in hexane (solid black line) and after the ligand exchange with cysteamine hydrochloride in water (dashed grey line).

In the second example, the procedure of example 1 was repeated successfully for CdSe quantum dots capped with oleic acid. FIG 6C displays a photograph of a vial 50 comprising the second phase liquid 20 and the quantum dots 1 that are capped with a shell of second ligands after centrifugation at the bottom of the vial.

In the third example the procedure of example 1 was repeated for Au quantum dots 1 capped with oleylamine

in heptane. FIG 6B displays a photograph of a vial 50 comprising an ink 100 comprising the quantum dots 1 that are capped with a shell of second ligands redispersed in water. FIG 6D displays a photograph of a vial 50 comprising an ink 100 comprising the CdSe quantum dots of the third example redispersed in water.

In the fourth, fifth and sixth example, the experiments of examples 1-3 were repeated using sodium 2-sulfanylethanesulfonate as second ligand. in these examples 1 mL of acetone (anti-solvent) was added to the second phase to precipitate the quantum dots. For systems using cysteamine hydrochloride DMF addition of an anti-solvent is possible but not needed. Otherwise results are comparable.

In a seventh example the ligand exchange process was repeated for PbS quantum dots capped with oleic acid using disulfide of cysteamine hydrochloride as second ligand. The disulfide of cysteamine hydrochloride was found to be poorly soluble in DMF, but was soluble in DMSO. Therefore the otherwise similar process was conducted using DMSO as solvent. Complete ligand exchange was observed and a pellet of PbS quantum dots that are capped with a shell of cysteamine hydrochloride ligands was obtained after centrifugation.

The QDs and ink composition as described herein can be of particular benefit for optoelectronic devices. Under reference to FIGs 9-14 various aspects and benefits will be explained as to QDs according to the invention and their application in optoelectronic devices such as field effect transistors, photo detectors, such as IR photo detectors and X-ray detectors, photodiodes, and solar cells. Unless otherwise specified the devices were prepared using commonly known procedures.

FIG 9A illustrates output characteristics of an exemplary field-effect transistor, fabricated with PbS QDs capped cysteamine hydrochloride as active material. Note that the plot displays both the reverse and forward scans indicating that hysteresis is very low.

FIG 9B depicts the transfer characteristics of the field-effect transistor. Solid lines represent the forward scans and the dashed lines represent the reverse voltage scan. The linear mobility for electrons was found to be 3.1E-4 $cm^2$/Vs.

FIG 10A schematically depicts the device schematics of an infrared photodetector made with a photoactive layer comprising cysteamine HCl-capped PbS QDs according to the invention. The QDs were spray-coated in air on top of a Glass/ITO substrate coated by 100 nm ZnO nanoparticles to form 600 nm thick layer. The device was completed by thermal evaporation of 7 nm MoOx and 80 nm gold top contact.

FIG 10B demonstrates optical properties of cysteamine HCl-capped quantum dots, deposited in a thin film (600 nm) as a photoactive layer in the infrared photodetector. It shows a clear absorption peak in infrared region (at 1450 nm), which is slightly red-shifted compared to original OA-capped quantum dot solution (at 1420 nm). The light scattering in the quantum dot film causes increased measured absorption values, and explains non-zero absorption at the wavelength longer than the absorption peak position.

FIG 11A depicts a JV curve of the photodiode in dark. The device has an off-current of 3.4*10E-4 mA/cm2 for 1V reverse voltage bias, which is a low value for quantum dots with the absorption properties shown in figure 10B. The diode shows the current rectification ratio of 6.2*10E3, which demonstrates good charge transport in the forward direction and efficient charge carrier blocking in reverse direction.

For the external quantum efficiency (EQE) measurements, the current response was measured under short-circuit conditions (photocurrent operation mode, V=0 V), while illuminating the area of the device (4x4 mm2) through 3mm-diameter opening. FIG 11B depicts the corresponding responsivity curve.

Based on the responsivity curve, the EQE values were calculated (FIG 12A). The measured EQE (bottom, black curve) reaches 9.5% at 1450nm. Since ITO electrode causes a considerable loss of the EQE, a correction was implemented (upper, red curve). This demonstrates that the internal quantum efficiency (IQE) reaches 15.4% with the absorption of 55% (not corrected for the fraction of light, that is scattered and not absorbed). Thus 15.4/55 = 28% of absorbed or scattered infrared photons are converted into charges and extracted from the device without applying reverse voltage bias.

To calculate the specific detectivity D*, the device was measured under reverse voltage bias in dark and under monochromatic illumination. FIG 12B displaying the dark current of the device and the current measured under 1450 nm monochromatic light (860 nW) under reverse voltage bias of 0.1 V, 0.5 V, and 1 V. When the dark current is dominated by the shot noise, D* can be expressed as follows:

$$D^* = \frac{R(\lambda)}{\sqrt{2eJ_{dark}}}[cm\ Hz^{1/2}W^{-1}]$$

where R is the responsivity and $J_{dark}$ is the dark current density.

This brings the values of the specific detectivity of 1.3E12 Jones for 0.1V, 9.6E11 Jones for 0.5V and 7.2E11 Jones for 1V bias.

FIG 13A displays JV characteristics under AM 1.5 light illumination of a solar cell comprising an active layer

with cysteamine HCl-capped PbS QDs according to the invention. The device was found to have a short circuit current $J_{sc}$ of 18.6 mA/cm^2; an open circuit potential $V_{oc}$ of 0.5V; a fill factor FF of 0.48; and a maximum power point (MPP) at 4.46 mW/$cm^2$.

FIG 13B depicts the JV-characteristics of an X-ray sensitive photodiode (as shown in FIG 5) in dark (bottom trace) and under white light illumination (top trace). The thickness of QD layer is 600 nm.

FIG 14A depicts the current response of the device to X-ray pulses (~10s each) (HP Faxitron 43855A, tungsten anode, 58kV voltage, 2 mA current) for 1 V reverse voltage. Rise time is limited by the source turning on time, and fall time is limited by the measurement equipment. FIG 14B displays the performance in terms of the leakage current and X-ray response current.

As comparative examples inventors attempted to prepare cysteamine hydrochloride capped quantum dots according to the method disclosed by Hak Soo Choi et al (Nature biotechnology 25; 1165-1170 (2007). To this end equal volumes of a chloroform solution of oleate-capped PbS QDs were mixed with 30 mM solutions of cysteamine hydrochloride dissolved in watery PBS buffer. However, even after prolonged stirring (>12h), no ligand exchange (LE) was observed. In contrast, the method of ligand exchange according to the invention was complete after about 30 seconds.

In addition, it was attempted perform ligand exchange in a hexane/water mixture (oleate-capped PbS QDs in hexane; of cysteamine hydrochloride in water). Inventors surprisingly found that ligand exchange can be promoted by addition of a third solvent to the biphasic mixture. The third solvent being miscible with both hexane and water.

## Claims

1. A method of manufacturing an ink composition (100) for depositing of a photoactive layer of an optoelectronic device, the method comprising

   - providing a first phase liquid (10) comprising a nonpolar solvent (11) with nanoparticles (1) dispersed in the nonpolar solvent, which nanoparticles are capped with a shell (2s) of first ligands (2), the first ligands (2) comprising a surface binding head group (2h) and an alkyl or alkenyl tail (2t) for, at least initially, keeping the nanoparticles (1) in a colloidal suspension in the nonpolar solvent (11);
   - providing a second phase liquid (20) comprising a first polar solvent (21) with second ligands (3) dissolved therein, the second ligands having a molecular architecture including:

     ◦ a thiol head group (3h) for binding to a surface site of said nanoparticle (1);
     ◦ an ionically charged tail group (3t) having a counter ion (3c) associated therewith; and
     ◦ an alkyl spacer separating the head group and the tail group having a total number of carbon atoms in a range from 1 to 3,

   - a biphasic ligand exchange process wherein the second ligands displace the first ligands that are bound to the nanoparticles (1) thereby releasing the first ligands to the first phase liquid (10), the biphasic ligand exchange process comprising contacting the first (10) and second phase liquid (20) to form a dispersion of the nanoparticles (1) that are capped with a shell (3s) of the second ligands (3) in the second phase liquid.

2. The method according to the preceding claim, wherein the second ligands (3) are:

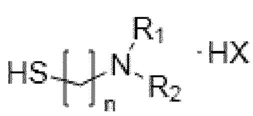

or

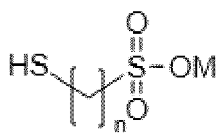

wherein

"n" is between 1 and 3;
"$R_1$" and "$R_1$" are each independently selected from H and methyl;
"X" is a halide, preferably Cl; and
"M" is an alkali metal, preferably Na or K.

3. The method according to claim 1 or 2, comprising

- separating the nanoparticles that are capped with a shell of the second ligands from the first polar solvent; and
- redispersing the separated nanoparticles (1) in a printable liquid medium (30) comprising a second polar solvent.

**4.** The method according to any of the preceding claims, wherein

- the first polar solvent comprises N,N-dimethylformamide, N-methylformamide, or a combination thereof; and
- the second polar solvent comprises an at least partially fluorinated lower alcohol, or a mixture of water and ethylene glycol, wherein the volume fraction of ethylene glycol in the mixture is in a range between five and fifty percent.

**5.** The method according to any of the preceding claims, comprising dissolving a disulfide moiety into the second phase liquid (20) so as to form the second ligands as dissociation products of the disulfide moiety.

**6.** The method according to any of the preceding claims, the method comprising

- determining an amount of the second ligand that is to be comprised in the first polar solvent (21) relative to an amount needed to completely cap the nanoparticles (1) with a shell (3s) of the second ligands; and
- providing the second phase liquid (20) comprising the first polar solvent (21) with second ligands (3) in an amount of less than 1.05 times the pre-determined amount.

**7.** The method according to any of the preceding claims, comprising washing the separated nanoparticles with one or more portions of a solvent for the first ligand, and/or comprising adding a third solvent to the first phase liquid (10) and second phase liquid (20), the third solvent being miscible with both the nonpolar solvent (11) and the first polar solvent (21).

**8.** An ink composition for use in the deposition of a photoactive layer of an optoelectronic device, the ink composition comprising

- a colloidal suspension of nanoparticles in a printable liquid medium (30) comprising a polar solvent, wherein the nanoparticles are capped with a shell of second ligands (3) replacing an initial shell of different first ligands, wherein the second ligands have a molecular architecture including

  ◦ a thiol head group (3h) bound to a surface site of said nanoparticle (1);
  ◦ an ionically charged tail group (3t) having a counter ion (3c) associated therewith; and
  ◦ an alkyl spacer separating the head group and the tail group having a total number of carbon atoms n in a range from 1 to 3,

wherein the polar solvent comprises an at least partially fluorinated lower alcohol, or a mixture of water and ethylene glycol, wherein the volume fraction of ethylene glycol in the mixture is in a range between five and fifty percent, wherein the first ligands and free unbound second ligands are present in the ink composition in a concentration of < 10 μM.

**9.** The ink composition according to the preceding claim, wherein the composition is essentially without first ligands and free unbound second ligands.

**10.** The ink composition according to any of the preceding claims, wherein the second ligands (3) are:

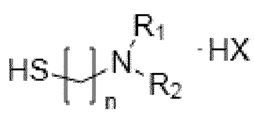

or

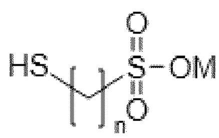

wherein

"n" is between 1 and 3;
"$R_1$" and "$R_1$" are each independently selected from H and methyl;
"X" is a halide, preferably Cl;

"M" is an alkali metal, preferably Na or K.

**11.** The ink composition according to any of the preceding claims, comprising a pyrrolidone additive and/or comprising one or more polymeric additive (33).

**12.** The ink composition according to any of the preceding claims, comprising a p-type dopant (31) or an n-type dopant.

**13.** A method of manufacturing an imaging device (1000) comprising a stack of photoactive layers (110) including at least a p-type photoactive layer (110p) and an n-type photoactive layer (110n), the method comprising

- depositing one or more layers of the ink composition comprising a p-type dopant according to the preceding claim; and
- depositing one or more layers of the ink composition comprising a n-type dopant according to the preceding claim;
- the deposited layers forming a stack of photoactive layers (110) including at least a p-type photoactive layer (110p) and an n-type photoactive layer (110n), wherein the photoactive layers are amorphous, comprising a disordered structure of nanoparticles formed by quantum dots resulting from the deposition by applying the respective ink compositions comprising colloidal quantum dots.

**14.** A dry composition, comprising the nanoparticles that are capped with a shell of second ligand (3) obtainable by

- performing the method according to any of claims 1-7;
- separating the nanoparticles that are capped with a shell of the second ligands from the first polar solvent of the second phase liquid; and
- drying the separated nanoparticles.

**15.** Use of the dry composition of the preceding claim in the manufacturing of a printable ink composition (100) by dispersing the dry composition in a polar solvent comprising an at least partially fluorinated lower alcohol, or a mixture of water and ethylene glycol, wherein the volume fraction of ethylene glycol in the mixture is in a range between five and fifty percent.

**Patentansprüche**

**1.** Verfahren zum Herstellen einer Tintenzusammensetzung (100) zum Aufbringen einer lichtempfindlichen Schicht einer optoelektronischen Vorrichtung, wobei das Verfahren umfasst:

- Bereitstellen einer Flüssigkeit (10) einer ersten Phase, umfassend ein unpolares Lösungsmittel (11) mit in dem unpolaren Lösungsmittel dispergierten Nanopartikeln (1), wobei die Nanopartikel mit einer Schale (2s) von ersten Liganden (2) eingekapselt sind, wobei die ersten Liganden (2) eine oberflächenbindende Kopfgruppe (2h) und einen Alkyl- oder Alkenylschwanz (2t) umfassen, um die Nanopartikel (1) zumindest anfänglich in einer kolloidalen Suspension in dem unpolaren Lösungsmittel (11) zu halten;
- Bereitstellen einer Flüssigkeit (20) einer zweiten Phase, umfassend ein erstes polares Lösungsmittel (21) mit darin gelösten zweiten Liganden (3), wobei die zweiten Liganden eine Molekülarchitektur haben mit:

  ◦ einer Thiol-Kopfgruppe (3h) zum Binden an eine Oberflächenstelle des Nanopartikels (1);
  ◦ einer ionisch geladenen Schwanzgruppe (3t), mit der ein Gegenion (3c) assoziiert ist; und
  ◦ einem Alkyl-Spacer, der die Kopfgruppe und die Schwanzgruppe voneinander trennt, miteiner Gesamtzahl von Kohlenstoffatomen in einem Bereich von 1 bis 3,

- einen zweiphasigen Ligandenaustauschvorgang, wobei die zweiten Liganden die an die Nanopartikel (1) gebundenen ersten Liganden verdrängen, wodurch die ersten Liganden in die Flüssigkeit (10) der ersten Phase freigegeben werden, wobei der zweiphasige Ligandenaustauschvorgang ein Kontaktieren der Flüssigkeiten (10, 20) der ersten und der zweiten Phase umfasst, um eine Dispersion aus den mit einer Hülle (3s) des zweiten Liganden (3) eingekapselten Nanopartikeln (1) in der Flüssigkeit der zweiten Phase auszubilden.

**2.** Verfahren nach dem vorhergehenden Anspruch, wobei die zweiten Liganden (3)

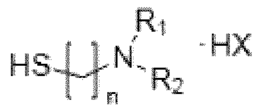

oder

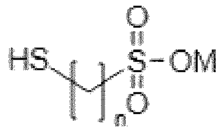

sind, wobei

"n" zwischen 1 und 3 ist;
"$R_1$" und "$R_1$" jeweils unabhängig ausgewählt sind aus H und Methyl;
"X" ein Halogenid, vorzugsweise Cl, ist; und
"M" ein Alkalimetall, vorzugsweise Na oder K, ist.

3. Verfahren nach Anspruch 1 oder 2, umfassend:

- Abscheiden der mit einer Hülle der zweiten Liganden eingekapselten Nanopartikel aus dem ersten polaren Lösungsmittel; und
- erneutes Dispergieren der abgeschiedenen Nanopartikel (1) in einem druckbaren flüssigen Medium (30), umfassend ein zweites polares Lösungsmittel.

4. Verfahren nach einem der vorhergehenden Ansprüche, wobei

- das erste polare Lösungsmittel N,N-Dimethylformamid, N-Methylformamid oder eine Kombination davon umfasst; und
- das zweite polare Lösungsmittel einen mindestens teilweise fluorierten niederen Alkohol oder eine Mischung aus Wasser und Ethylenglycol umfasst, wobei der Volumenanteil von Ethylenglycol in der Mischung in einem Bereich zwischen fünf und fünfzig Prozent ist.

5. Verfahren nach einem der vorhergehenden Ansprüche, umfassend Lösen eines Disulfidrests in der Flüssigkeit (20) der zweiten Phase, um die zweiten Liganden als Spaltungsprodukte des Disulfidrests auszubilden.

6. Verfahren nach einem der vorhergehenden Ansprüche, wobei das Verfahren umfasst:

- Bestimmen einer Menge des zweiten Liganden, der in dem ersten polaren Lösungsmittel (21) umfasst sein soll, relativ zu einer Menge, die benötigt wird, um die Nanopartikel (1) vollständig mit einer Hülle (3s) der zweiten Liganden einzukapseln; und
- Bereitstellen der Flüssigkeit (20) der zweiten Phase, umfassend das erste polare Lösungsmittel (21), mit zweiten Liganden (3) in einer Menge von weniger als das 1,05-fache der zuvor bestimmten Menge.

7. Verfahren nach einem der vorhergehenden Ansprüche, umfassend Waschen der abgeschiedenen Nanopartikel mit einem oder mehreren Teilen eines Lösungsmittels für den ersten Liganden, und/oder umfassend Zugeben eines dritten Lösungsmittels in die Flüssigkeit (10) der ersten Phase und die Flüssigkeit (20) der zweiten Phase, wobei das dritte Lösungsmittel sowohl mit dem unpolaren Lösungsmittel (11) als auch mit dem ersten polaren Lösungsmittel (21) mischbar ist.

8. Tintenzusammensetzung zur Verwendung beim Aufbringen einer lichtempfindlichen Schicht einer optoelektronischen Vorrichtung, wobei die Tintenzusammensetzung umfasst:

- eine kolloidale Lösung von Nanopartikeln in einem druckbaren flüssigen Medium (30), umfassend ein polares Lösungsmittel, wobei die Nanopartikel mit einer Schale von zweiten Liganden (3) eingekapselt sind, die eine anfängliche Schale von unterschiedlichen ersten Liganden ersetzt, wobei die zweiten Liganden eine Molekülarchitektur haben mit:

- ◦ einer Thiol-Kopfgruppe (3h), gebunden an eine Oberflächenstelle des Nanopartikels (1);
- ◦ einer ionisch geladenen Schwanzgruppe (3t), mit der ein Gegenion (3c) assoziiert ist; und
- ◦ einem Alkyl-Spacer, der die Kopfgruppe und die Schwanzgruppe voneinander trennt mit einer Gesamtzahl von Kohlenstoffatomen n in einem Bereich von 1 bis 3,

wobei das polare Lösungsmittel einen mindestens teilweise fluorierten niederen Alkohol oder eine Mischung aus Wasser und Ethylenglycol umfasst, wobei der Volumenanteil von Ethylenglycol in der Mischung in einem Bereich zwischen fünf und fünfzig Prozent ist, wobei die ersten Liganden und freie ungebundene zweite Liganden in der Tintenzusammensetzung in einer Konzentration von < 10 μM vorhanden sind.

**9.** Tintenzusammensetzung nach dem vorhergehenden Anspruch, wobei die Zusammensetzung im Wesentlichen frei von ersten Liganden und freien ungebundenen zweiten Liganden ist.

**10.** Tintenzusammensetzung nach einem der vorhergehenden Ansprüche, wobei die zweiten Liganden (3)

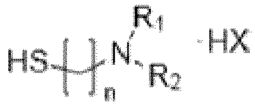

Oder

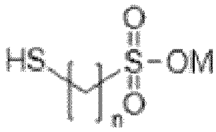

sind, wobei

"n" zwischen 1 und 3 ist;
"$R_1$" und "$R_1$" jeweils unabhängig ausgewählt sind aus H und Methyl;
"X" ein Halogenid, vorzugsweise Cl, ist;
"M" ein Alkalimetall, vorzugsweise Na oder K, ist.

**11.** Tintenzusammensetzung nach einem der vorhergehenden Ansprüche, umfassend ein Pyrrolidonadditiv und/oder umfassend ein oder mehrere polymerische Additive (33).

**12.** Tintenzusammensetzung nach einem der vorhergehenden Ansprüche, umfassend einen p-Typ Dotanden (31) oder einen n-Typ Dotanden.

**13.** Verfahren zum Herstellen einer bildgebenden Vorrichtung (1000) umfassend einem Stapel lichtempfindlicher Schichten (110), der mindestens eine lichtempfindliche p-Typ Schicht (110b) und eine lichtempfindliche n-Typ Schicht (110n), wobei das Verfahren umfasst:

- Aufbringen einer oder mehrere Schichten der Tintenzusammensetzung umfassend einen p-Typ Dotanden nach dem vorhergehenden Anspruch; und
- Aufbringen einer oder mehrere Schichten der Tintenzusammensetzung umfassend einen n-Typ Dotanden nach dem vorhergehenden Anspruch;
- wobei die aufgebrachten Schichten einen Stapel mit lichtempfindlichen Schichten (110) bilden, der mindestens eine lichtempfindliche p-Typ Schicht (110p) und eine lichtempfindliche n-Typ Schicht (110n) einschließt, wobei die lichtempfindlichen Schichten amorph sind, umfassend eine ungeordnete Struktur aus Nanopartikeln, gebildet durch Quantenpunkte, welche aus dem Aufbringen unter Anwendung der jeweiligen Tintenzusammensetzung, umfassend kolloidale Quantenpunkte, resultiert.

**14.** Trockene Zusammensetzung, umfassend die Nanopartikel, die mit einer Hülle des zweiten Liganden (3) eingekapselt

sind, erhältlich durch:

- Durchführen des Verfahrens nach einem der Ansprüche 1 bis 7;
- Abscheiden der Nanopartikel, die mit einer Hülle der zweiten Liganden eingekapselt sind, aus dem ersten polaren Lösungsmittel der Flüssigkeit der zweiten Phase; und
- Trocknen der abgeschiedenen Nanopartikel.

**15.** Verwendung der trockenen Zusammensetzung nach dem vorhergehenden Anspruch bei der Herstellung einer druckbaren Tintenzusammensetzung (100) durch Dispergieren der trockenen Zusammensetzung in einem polaren Lösungsmittel, umfassend einen mindestens teilweise fluorierten niederen Alkohol oder eine Mischung aus Wasser und Ethylenglycol, wobei der Volumenanteil von Ethylenglycol in der Mischung in einem Bereich zwischen fünf und fünfzig Prozent ist.

## Revendications

**1.** Procédé de fabrication d'une composition d'encre (100) pour un dépôt d'une couche photoactive d'un dispositif optoélectronique, le procédé comprenant les étapes consistant à

- fournir un liquide de première phase (10) comprenant un solvant non polaire (11) avec des nanoparticules (1) dispersées dans le solvant non polaire, lesquelles nanoparticules sont coiffées d'une enveloppe (2s) de premiers ligands (2), les premiers ligands (2) comprenant un groupe de tête de liaison de surface (2h) et une queue alkyle ou alcényle (2t) pour, au moins initialement, maintenir les nanoparticules (1) dans une suspension colloïdale dans le solvant non polaire (11) ;
- fournir un liquide de seconde phase (20) comprenant un premier solvant polaire (21) dans lequel sont dissous des seconds ligands (3), les seconds ligands présentant une architecture moléculaire comprenant :

  • un groupe de tête thiol (3h) pour une liaison à un site de surface de ladite nanoparticule (1) ;
  • un groupe de queue chargé ioniquement (3t) auquel est associé un contre-ion (3c) ; et
  • un espaceur alkyle séparant le groupe de tête et le groupe de queue, présentant un nombre total d'atomes de carbone dans une plage allant de 1 à 3,

- un procédé d'échange de ligands biphasique dans lequel les seconds ligands déplacent les premiers ligands qui sont liés aux nanoparticules (1), en libérant ainsi les premiers ligands vers le liquide de première phase (10), le procédé d'échange de ligands biphasique comprenant une mise en contact des liquides de première (10) et de seconde phase (20) pour former une dispersion des nanoparticules (1) qui sont coiffées d'une enveloppe (3s) des seconds ligands (3) dans le liquide de seconde phase.

**2.** Procédé selon la revendication précédente, dans lequel les seconds ligands (3) sont :

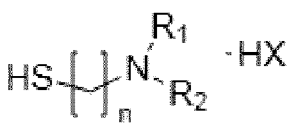

ou

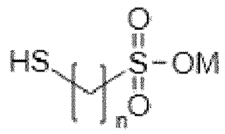

dans lequel

« n » est compris entre 1 et 3 ;
« $R_1$ » et « $R_1$ » sont choisis chacun indépendamment parmi H et méthyle ;
« X » est un halogénure, de préférence Cl ; et
« M » est un métal alcalin, de préférence Na ou K.

**3.** Procédé selon la revendication 1 ou 2, comprenant les étapes consistant à

- séparer les nanoparticules qui sont coiffées d'une enveloppe des seconds ligands à partir du premier solvant polaire ; et

- redisperser les nanoparticules séparées (1) dans un milieu liquide imprimable (30) comprenant un deuxième solvant polaire.

**4.** Procédé selon l'une quelconque des revendications précédentes, dans lequel :

- le premier solvant polaire comprend du N,N-diméthylformamide, du N-méthylformamide, ou une combinaison de ceux-ci ; et
- le deuxième solvant polaire comprend un alcool inférieur au moins partiellement fluoré, ou un mélange d'eau et d'éthylène glycol, dans lequel la fraction volumique d'éthylène glycol dans le mélange est comprise entre cinq et cinquante pour cent.

**5.** Procédé selon l'une quelconque des revendications précédentes, comprenant la dissolution d'une fraction disulfure dans le liquide de second phase (20) de manière à former les seconds ligands en tant que produits de dissociation de la fraction disulfure.

**6.** Procédé selon l'une quelconque des revendications précédentes, le procédé comprenant les étapes consistant à

- déterminer une quantité du second ligand qui doit être comprise dans le premier solvant polaire (21) par rapport à une quantité nécessaire pour coiffer complètement les nanoparticules (1) avec une enveloppe (3s) des seconds ligands ; et
- fournir au liquide de seconde phase (20) comprenant le premier solvant polaire (21) des seconds ligands (3) en une quantité inférieure à 1,05 fois la quantité prédéterminée.

**7.** Procédé selon l'une quelconque des revendications précédentes, comprenant le lavage des nanoparticules séparées avec une ou plusieurs parties d'un solvant pour le premier ligand, et/ou comprenant l'ajout d'un troisième solvant au liquide de première phase (10) et au liquide de seconde phase (20), le troisième solvant étant miscible à la fois avec le solvant non polaire (11) et le premier solvant polaire (21).

**8.** Composition d'encre à utiliser dans le dépôt d'une couche photoactive d'un dispositif optoélectronique, la composition d'encre comprenant

- une suspension colloïdale de nanoparticules dans un milieu liquide imprimable (30) comprenant un solvant polaire, dans laquelle les nanoparticules sont coiffées d'une enveloppe de seconds ligands (3) remplaçant une enveloppe initiale de premiers ligands différents, dans laquelle les seconds ligands présentent une architecture moléculaire comprenant

    • un groupe de tête thiol (3h) lié à un site de surface de ladite nanoparticule (1) ;
    • un groupe de queue chargé ioniquement (3t) auquel est associé un contre-ion (3c) ; et
    • un espaceur alkyle séparant le groupe de tête et le groupe de queue présentant un nombre total d'atomes de carbone n dans une plage allant de 1 à 3,

dans laquelle le solvant polaire comprend un alcool inférieur au moins partiellement fluoré, ou un mélange d'eau et d'éthylène glycol, dans laquelle la fraction volumique d'éthylène glycol dans le mélange se trouve dans une plage allant de cinq à cinquante pour cent, dans laquelle les premiers ligands et les seconds ligands libres non liés sont présents dans la composition d'encre à une concentration < 10 μM.

**9.** Composition d'encre selon la revendication précédente, dans laquelle la composition est essentiellement dépourvue de premiers ligands et de seconds ligands libres non liés.

**10.** Composition d'encre selon l'une quelconque des revendications précédentes, dans lequel les seconds ligands (3) sont :

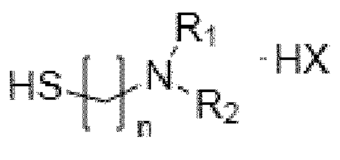

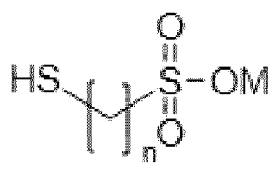

ou

dans laquelle

« n » est compris entre 1 et 3 ;
« $R_1$ » et « $R_1$ » sont choisis chacun indépendamment parmi H et méthyle ;
« X » est un halogénure, de préférence Cl ;
« M » est un métal alcalin, de préférence Na ou K.

**11.** Composition d'encre selon l'une quelconque des revendications précédentes, comprenant un additif de pyrrolidone et/ou comprenant un ou plusieurs additifs polymères (33).

**12.** Composition d'encre selon l'une quelconque des revendications précédentes, comprenant un dopant de type p (31) ou un dopant de type n.

**13.** Procédé de fabrication d'un dispositif d'imagerie (1000) comprenant un empilement de couches photoactives (110) comprenant au moins une couche photoactive de type p (110p) et une couche photoactive de type n (110n), le procédé comprenant les étapes consistant à

- déposer une ou plusieurs couches de la composition d'encre comprenant un dopant de type p selon la revendication précédente ; et
- déposer une ou plusieurs couches de la composition d'encre comprenant un dopant de type n selon la revendication précédente ;
- les couches déposées formant un empilement de couches photoactives (110) comprenant au moins une couche photoactive de type p (110p) et une couche photoactive de type n (110n), dans lequel les couches photoactives sont amorphes, comprenant une structure désordonnée de nanoparticules formées par des points quantiques résultant du dépôt en appliquant les compositions d'encre respectives comprenant des points quantiques colloïdaux.

**14.** Composition sèche, comprenant les nanoparticules qui sont coiffées d'une enveloppe de second ligands (3) pouvant être obtenue par l'intermédiaire des étapes consistant à

- effectuer le procédé selon l'une quelconque des revendications 1 à 7 ;
- séparer les nanoparticules qui sont coiffées d'une enveloppe des seconds ligands à partir du premier solvant polaire du liquide de seconde phase ; et
- sécher les nanoparticules séparées.

**15.** Utilisation de la composition sèche selon la revendication précédente dans la fabrication d'une composition d'encre imprimable (100) en dispersant la composition sèche dans un solvant polaire comprenant un alcool inférieur au moins partiellement fluoré, ou un mélange d'eau et d'éthylène glycol, dans laquelle la fraction volumique d'éthylène glycol dans le mélange se trouve dans une plage allant de cinq à cinquante pour cent.

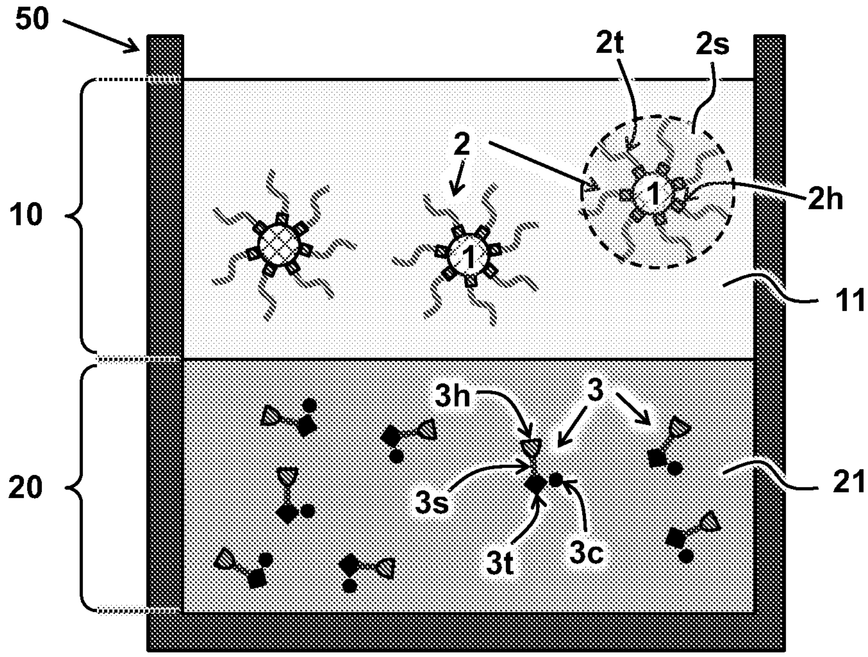


FIG 1A

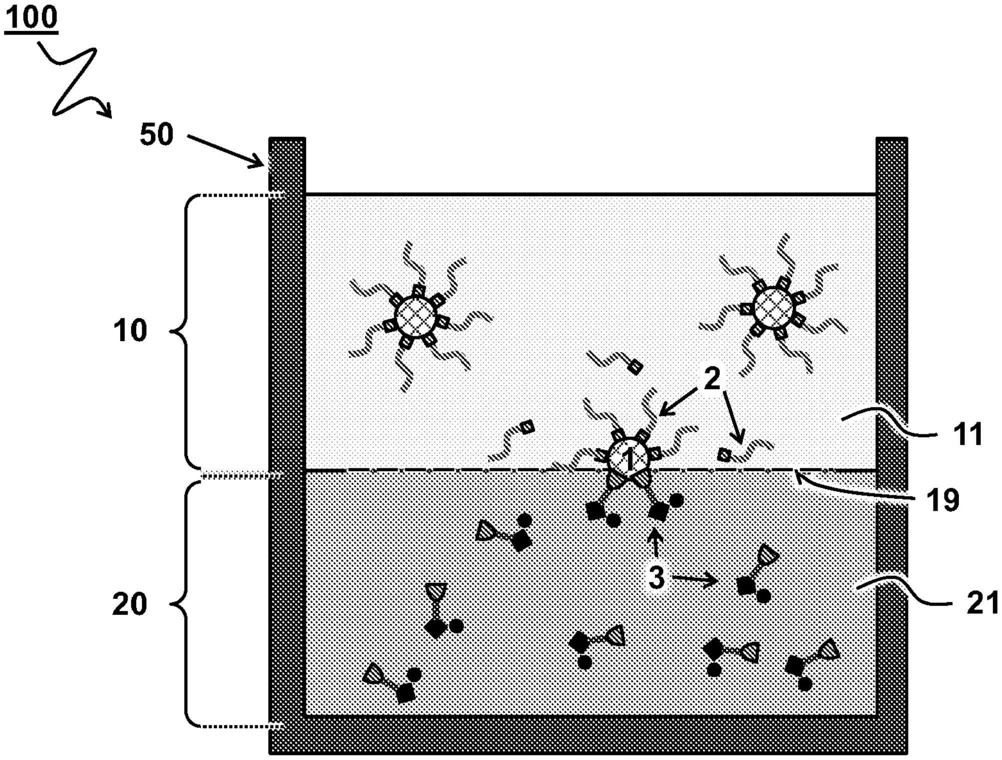


FIG 1B

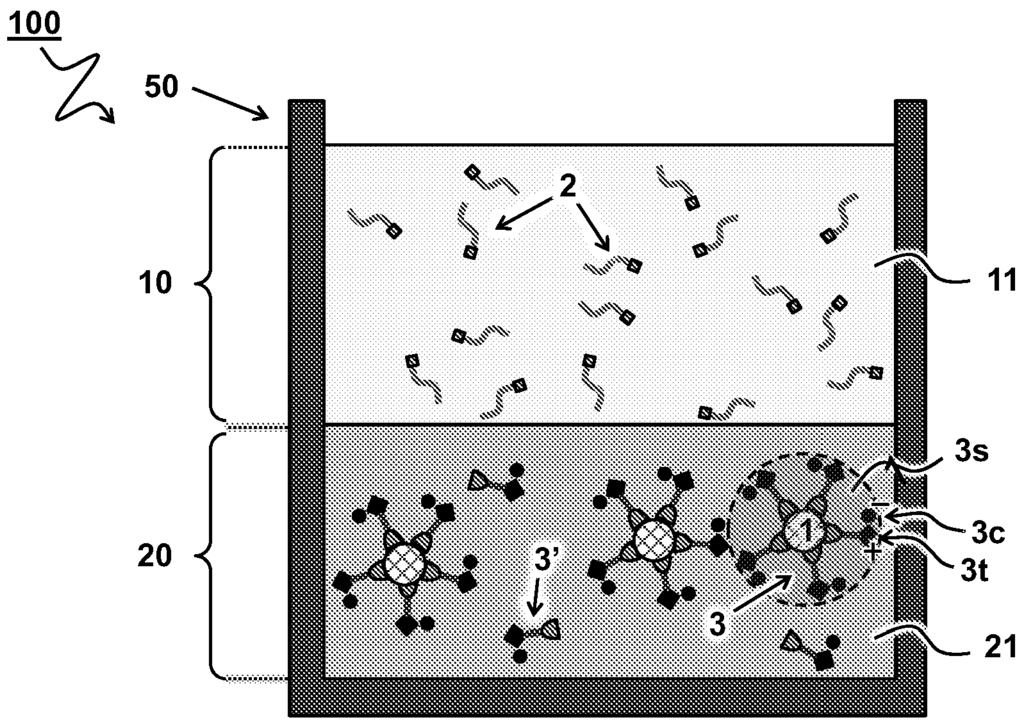


FIG 2A

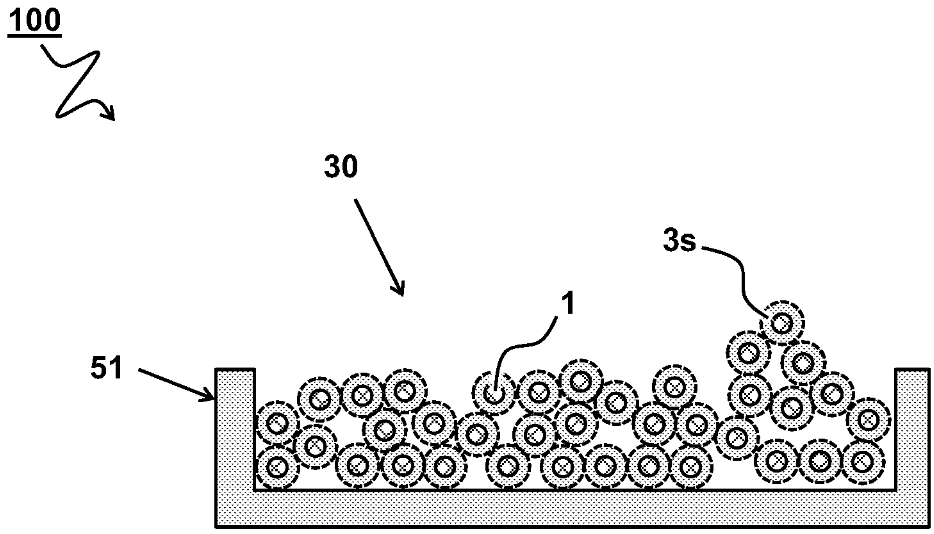


FIG 2B

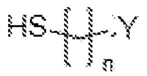

**3**

FIG 3A

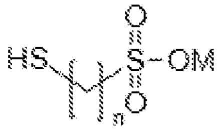

**3**

FIG 3B

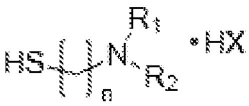

**3**

FIG 3C

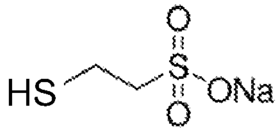

**3**

FIG 3D

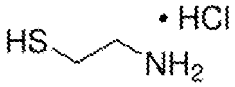

**3**

FIG 3E

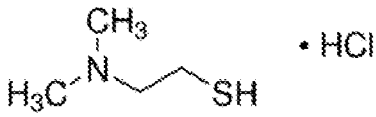

**3**

FIG 3F

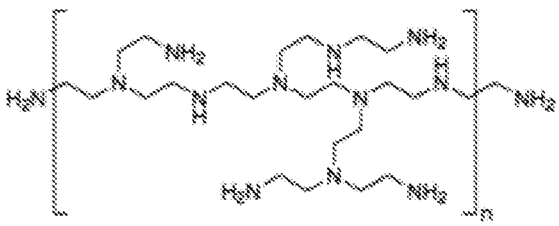

**33a**

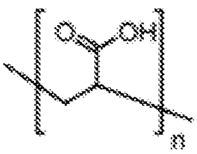

**33b**

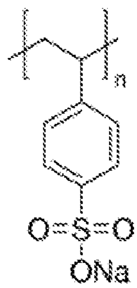

**33c**

FIG 3G

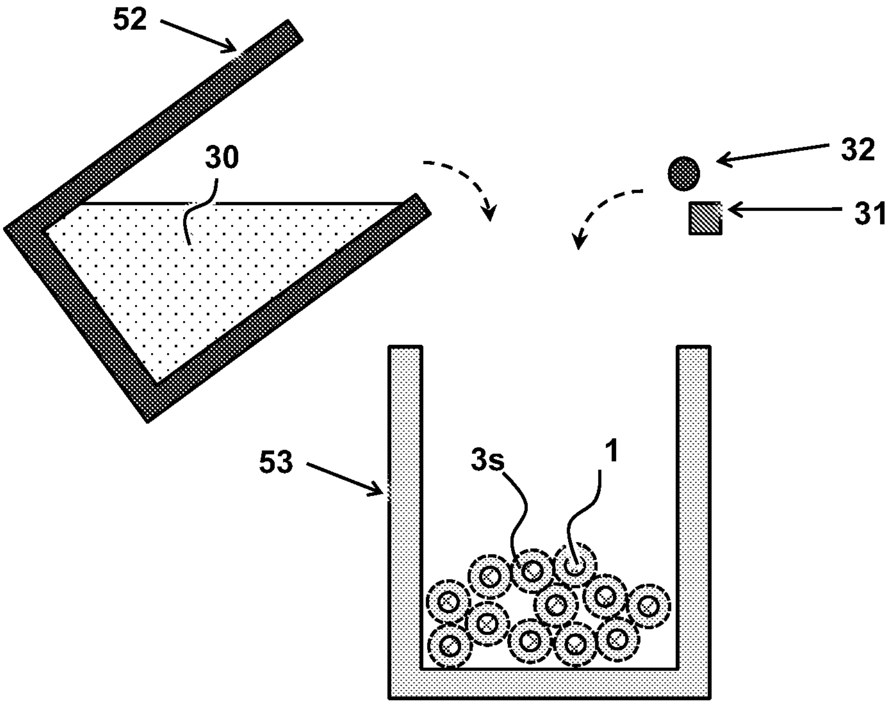


FIG 4A

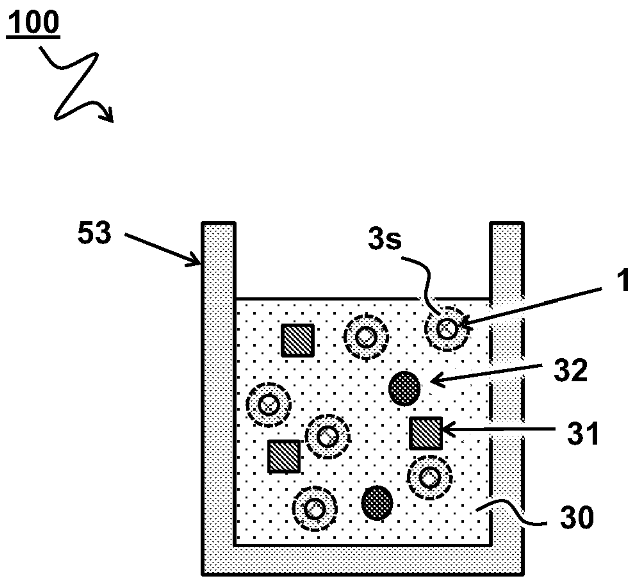


FIG 4B

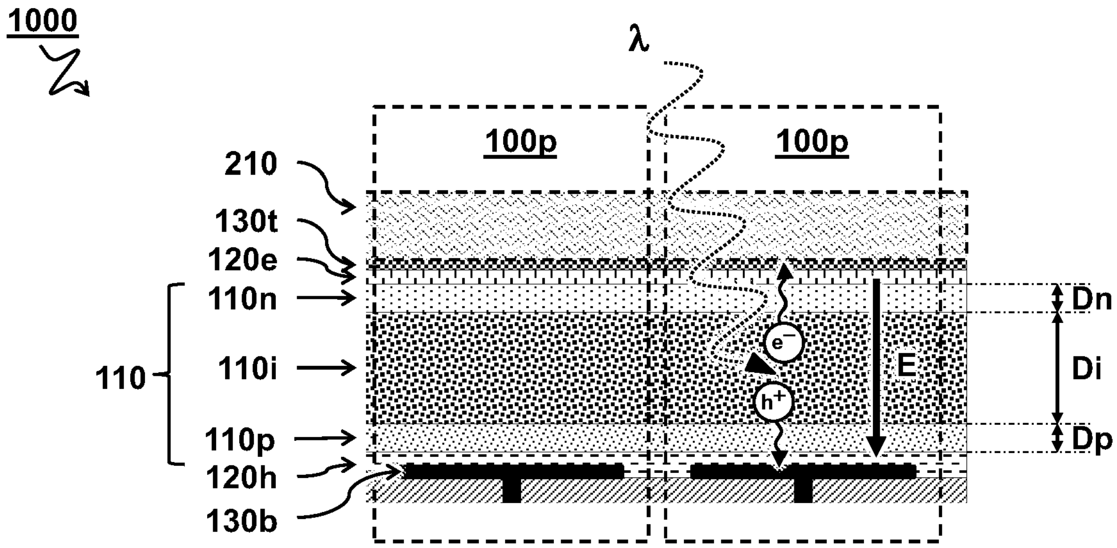
1000
λ
100p
100p
210
130t
120e
110n
110
110i
110p
120h
130b
e⁻
h⁺
E
Dn
Di
Dp

FIG 5

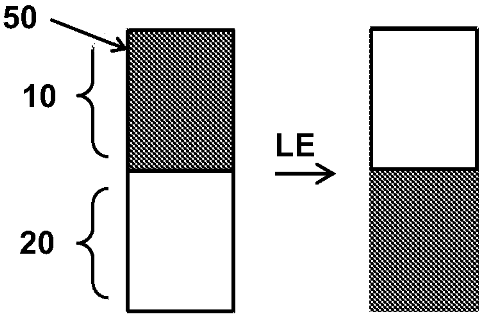


FIG 6A

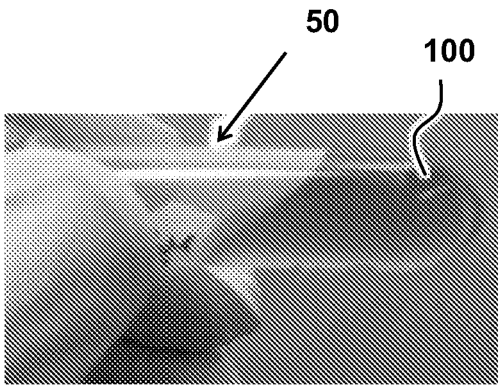


FIG 6B

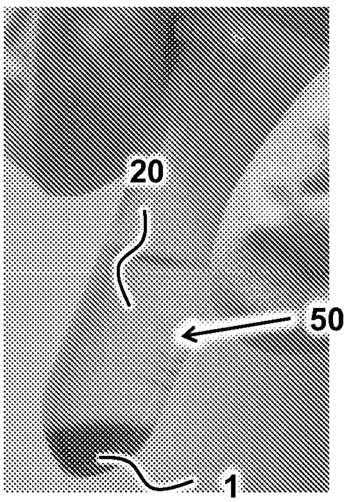


FIG 6C

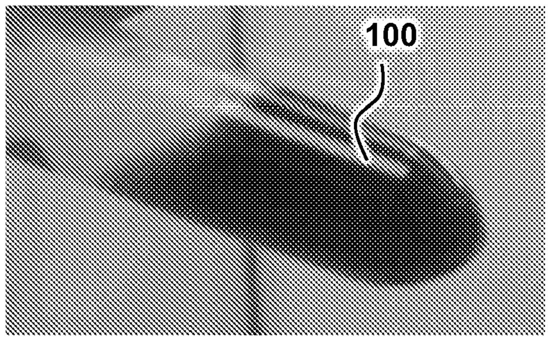


FIG 6D

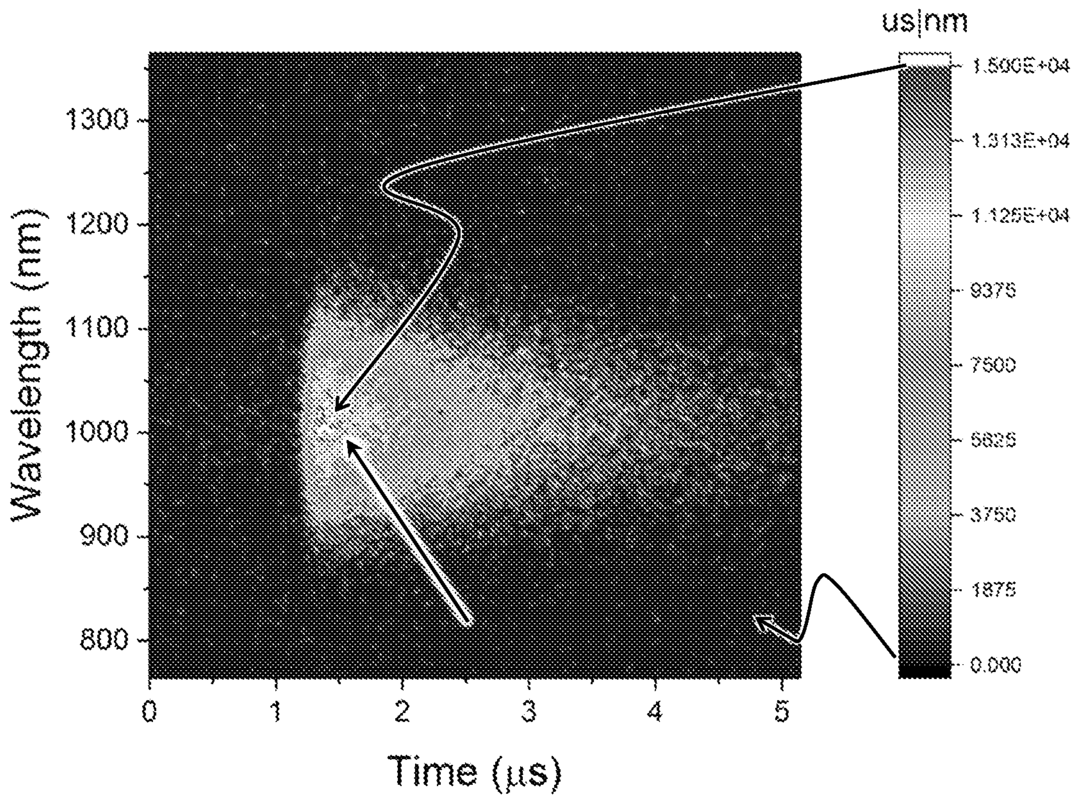
us|nm
1.500E+04
1.313E+04
1.125E+04
9375
7500
5625
3750
1875
0.000
Wavelength (nm)
1300
1200
1100
1000
900
800
0
1
2
3
4
5
Time (μs)

FIG 7A

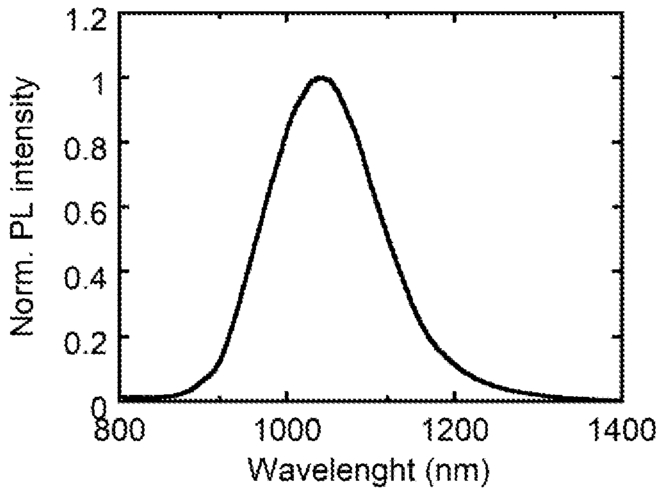
Norm. PL intensity
1.2
1
0.8
0.6
0.4
0.2
0
800
1000
1200
1400
Wavelenght (nm)

FIG 7B

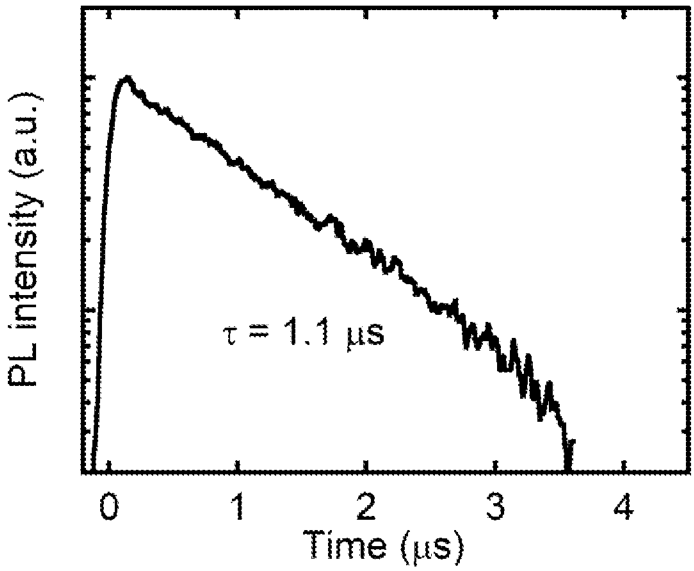


FIG 8A

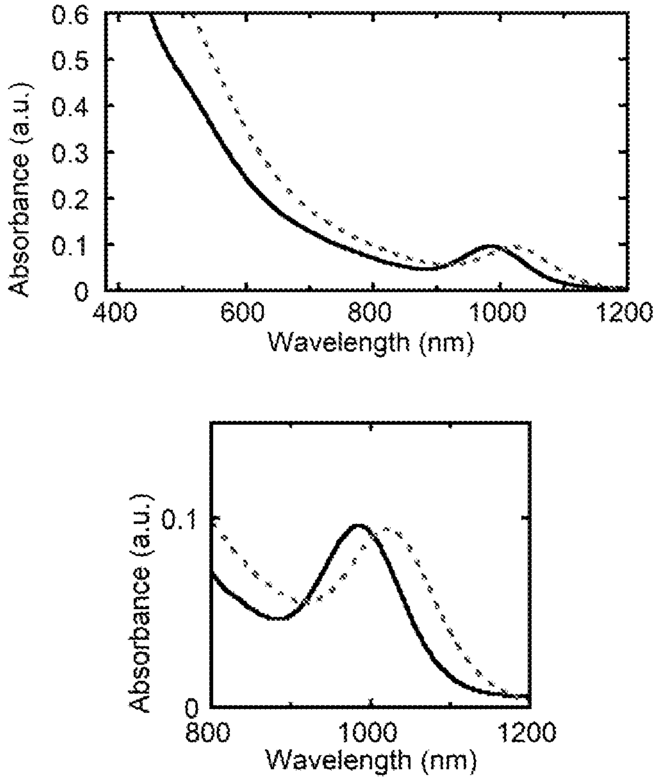


FIG 8B

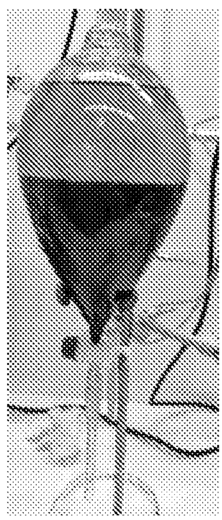

FIG 8C

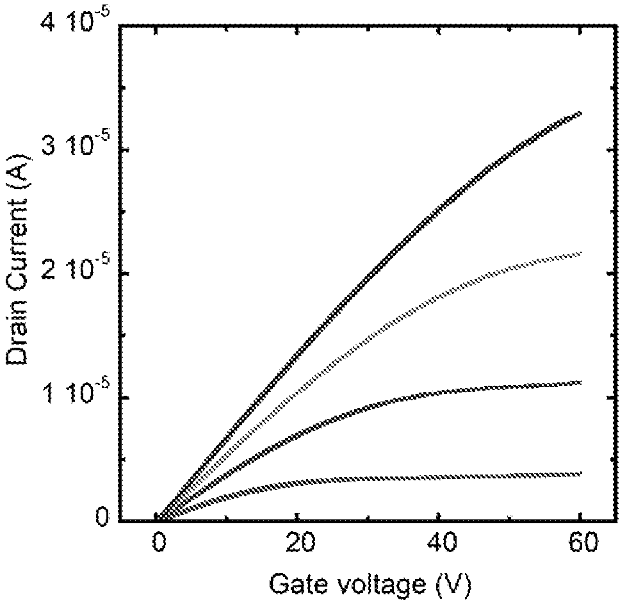

4 10-5
3 10-5
2 10-5
1 10-5
0
Drain Current (A)
0
20
40
60
Gate voltage (V)


FIG 9A

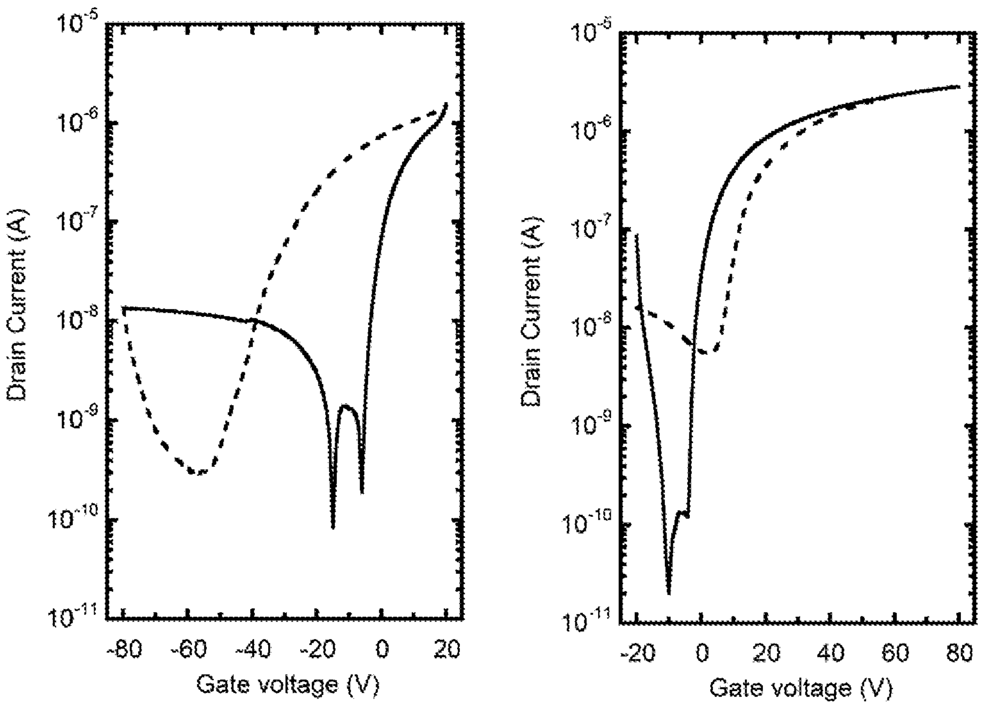

10-5
10-6
10-7
10-8
10-9
10-10
10-11
Drain Current (A)
-80
-60
-40
-20
0
20
Gate voltage (V)
10-5
10-6
10-7
10-8
10-9
10-10
10-11
Drain Current (A)
-20
0
20
40
60
80
Gate voltage (V)


FIG 9B

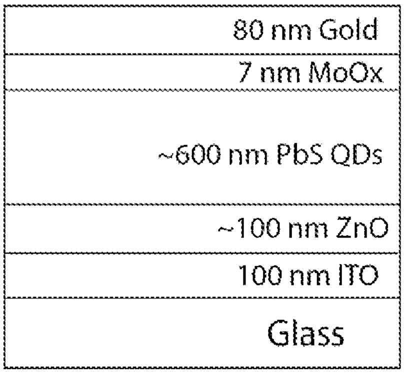


FIG 10A

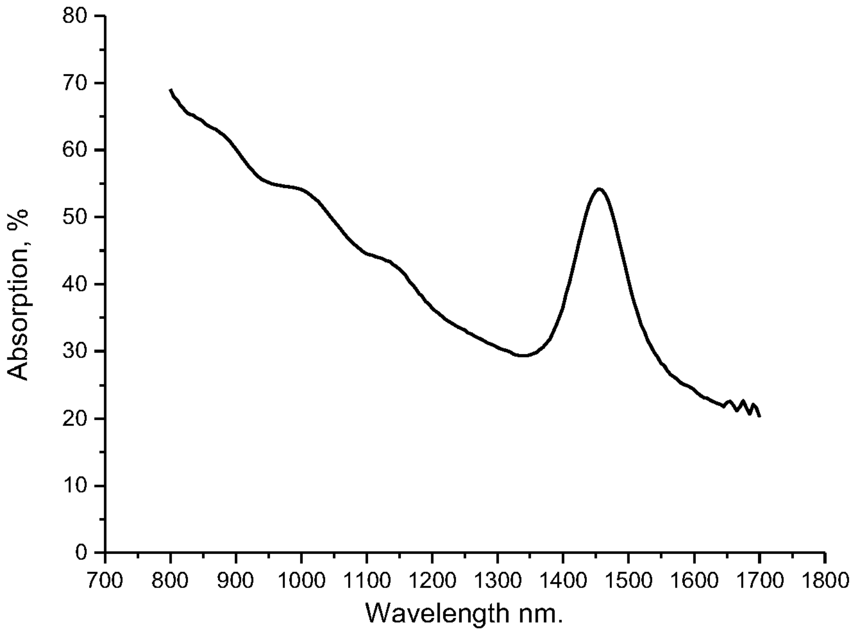


FIG 10B

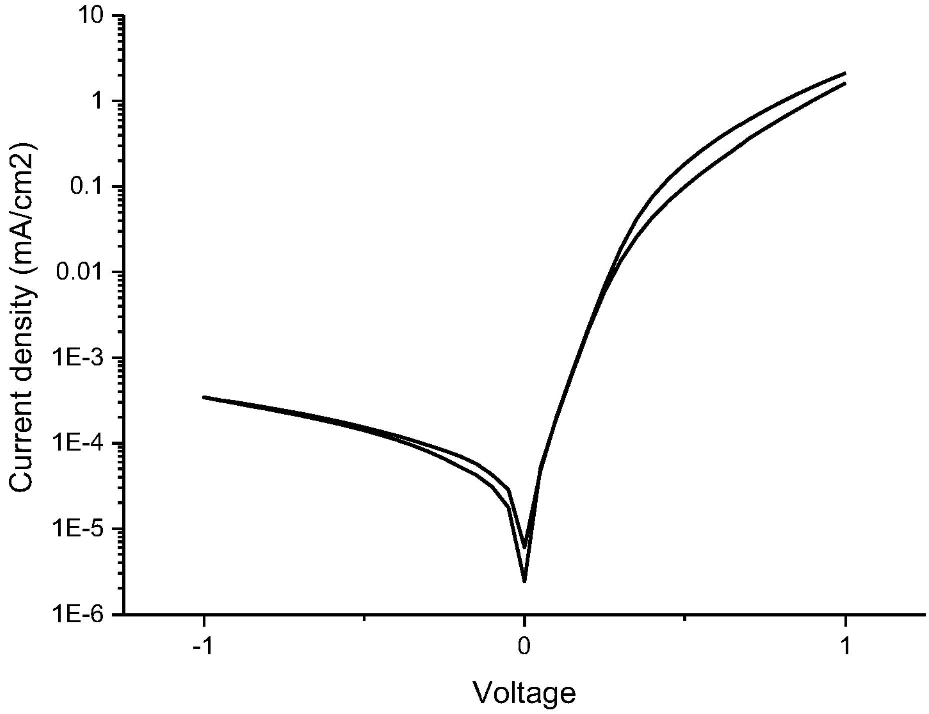


FIG 11A

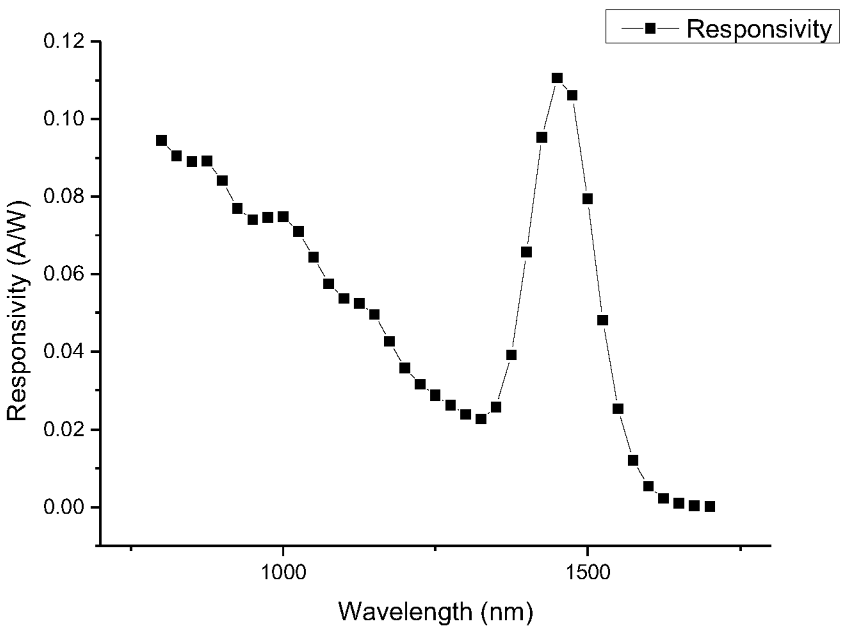


FIG 11B

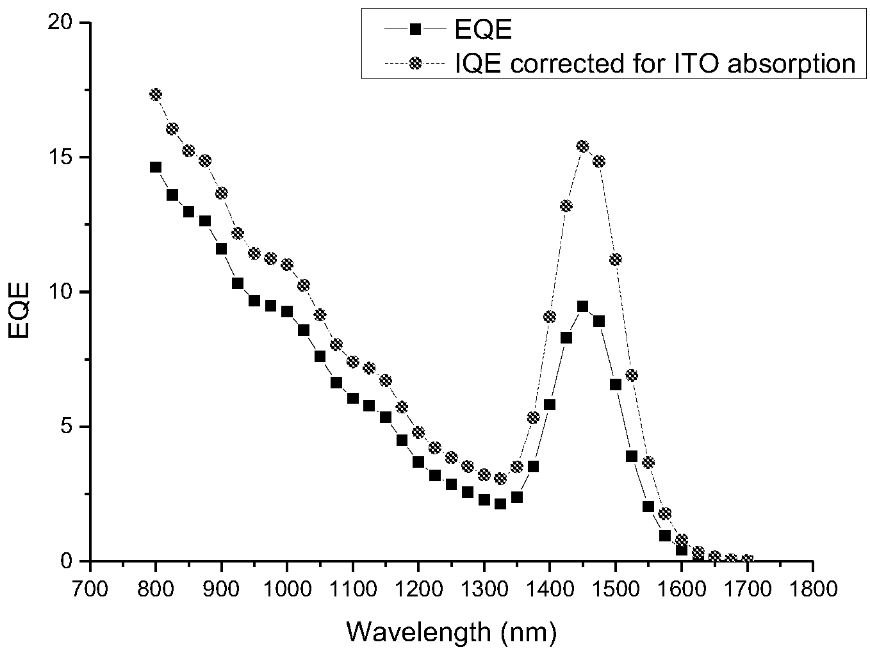


FIG 12A

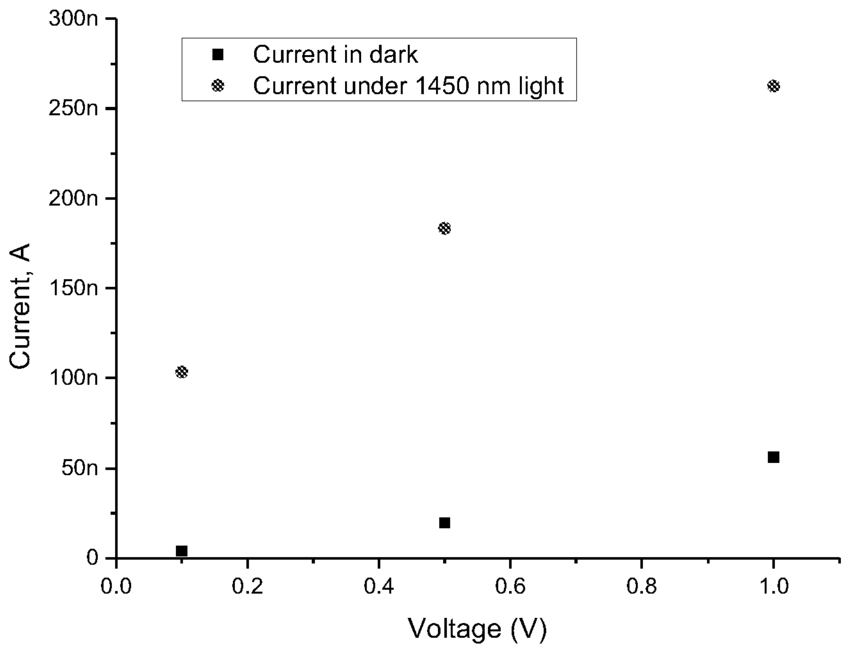


FIG 12B

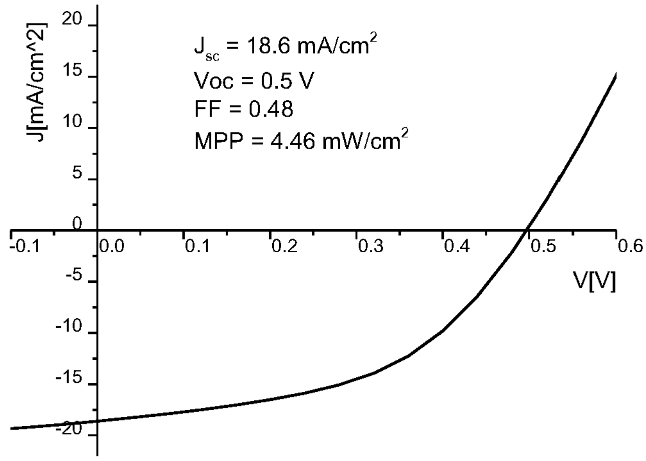


FIG 13A

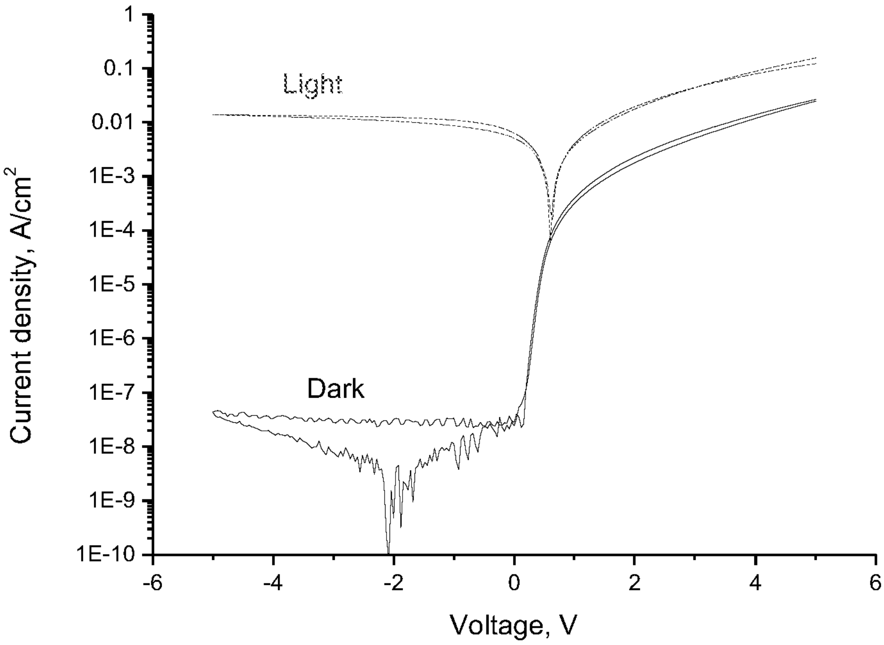


FIG 13B

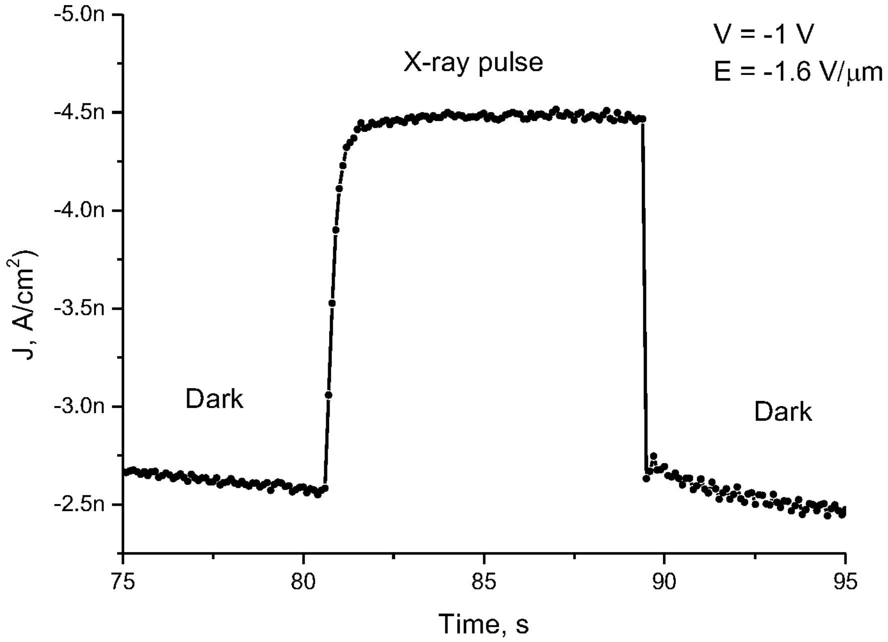


FIG 14A

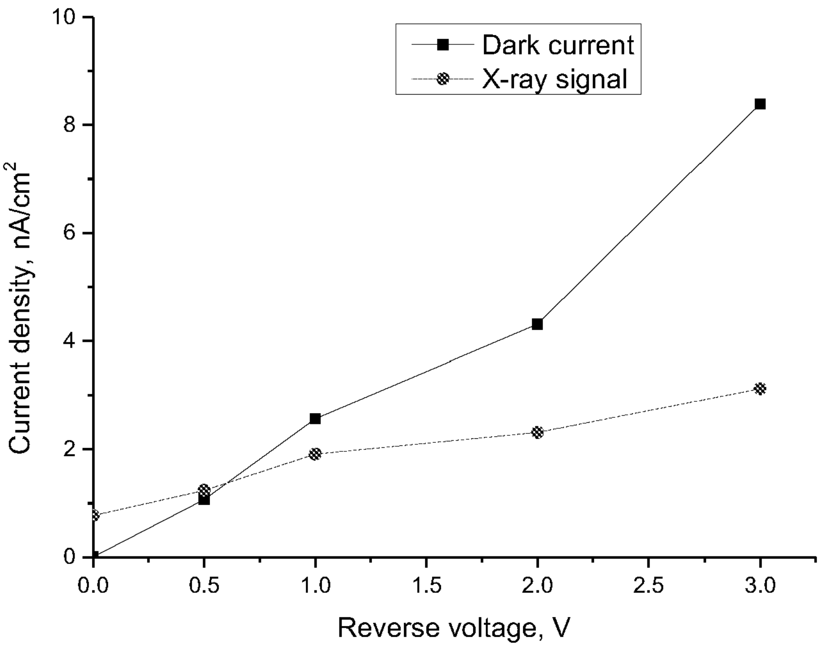


FIG 14B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 6251303 B1
- US 2007174939 A1
- WO 2019203240 A1


### Non-patent literature cited in the description


- **HAK SOO CHOI et al.** *Nature biotechnology,* 2007, vol. 25, 1165-1170
- **BYUNG-RYOOL HYUN.** *J. Phys. Chem. B,* 2007, vol. 111 (20), 5726-5730
- **NOIPA T et al.** *Spectrochim Acta A Mol Biomol Spectrosc.,* 24 January 2014, vol. 118, 17-23